Europäisches Patentamt

European Patent Office

Office européen des brevets

(19)

(11) Veröffentlichungsnummer: **0 283 487 B1**

(12) **EUROPÄISCHE PATENTSCHRIFT**

(45) Veröffentlichungstag der Patentschrift :
03.04.91 Patentblatt 91/14

(51) Int. Cl.⁵ : **H03K 17/945, H03K 17/95**

(21) Anmeldenummer : 87905940.0

(22) Anmeldetag : 21.09.87

(86) Internationale Anmeldenummer :
PCT/DE87/00426

(87) Internationale Veröffentlichungsnummer :
**WO 88/02579 07.04.88 Gazette 88/08**

(54) STÖRFELDUNEMPFINDLICHER NÄHERUNGSSCHALTER.

(30) Priorität : 25.09.86 DE 3632624

(43) Veröffentlichungstag der Anmeldung :
28.09.88 Patentblatt 88/39

(45) Bekanntmachung des Hinweises auf die
Patenterteilung :
03.04.91 Patentblatt 91/14

(84) Benannte Vertragsstaaten :
AT BE CH DE FR GB IT LI SE

(56) Entgegenhaltungen :
EP-A- 0 156 696
EP-A- 0 179 384
FR-A- 1 304 131

(73) Patentinhaber : Gebhard Balluff Fabrik
feinmechanischer Erzeugnisse GmbH & Co.
Gartenstrasse 21
W-7303 Neuhausen a.d.F. (DE)

(72) Erfinder : KAMMERER, Heinz
Achalmstrasse 29
W-7302 Ostfildern 2 (DE)
Erfinder : STUMPE, Reinhard
Lindenstrasse 36/1
W-7303 Neuhausen (DE)

(74) Vertreter : Hoeger, Stellrecht & Partner
Uhlandstrasse 14 c
W-7000 Stuttgart 1 (DE)

EP 0 283 487 B1

## Beschreibung

Die Erfindung betrifft einen störfeldunempfindlichen Näherungsschalter zum Positionsnachweis eines Maschinenelements mit mindestens einem Sensor, der nahe eines in einer zu detektierenden Stellung stehenden Maschinenelements ein Gesamtsignal mit einem durch das Maschinenelement hervorgerufenen Nachweisfeldsignalanteil und einem vom Störfeld hervorgerufenen zeitabhängigen Störfeldsignalanteil generiert und einem Schaltkreis übermittelt, welcher das Gesamtsignal in ein Ausgangssignal umsetzt.

Bei einer Vielzahl von Einsatzmöglichkeiten für Näherungsschalter besteht das Problem, daß im Bereich einer für den Näherungsschalter vorgesehenen Stelle Störfelder auftreten, welche den Sensor zur Erzeugung von als Störfeldsignalanteilen bezeichneten Signalen veranlassen und bei all den Näherungsschaltern zu Fehlschaltungen führen, die auf der Basis eines Nachweises eines elektrischen oder magnetischen Feldes arbeiten. Diese Störfelder weisen eine Zeitabhängigkeit auf. Beispielsweise können Quellen für derartige Störfelder Stromleitungen zu Schweißzangen von Schweißanlagen sein, welche aufgrund der großen Ströme zu magnetischen Störfeldern mit beachtlichen Feldstärken führen. Es sind aber auch eine Vielzahl anderer Möglichkeiten denkbar, bei denen elektrische, magnetische oder elektromagnetische Störfelder im Bereich eines Näherungsschalter auftreten können.

Aus der DE-A 34 38 120 ist ein störfeldfester Näherungsschalter bekannt, welcher zwei im Abstand zueinander angeordnete Sensoren aufweist, welche feldabhängige Signale erzeugen. Das Ausgangssignal dieses Näherungsschalters wird durch Differenzbildung der beiden feldabhängigen Signale und Vergleich eines Differenzsignals mit einer Schaltschwelle erzeugt.

Diese bekannten Näherungsschalter führen immer dann zu befriedigenden Ergebnissen, wenn die Störfelder am Ort der beiden Sensoren jeweils ungefähr gleich groß sind, oder sich zumindest um einen Betrag unterscheiden, der kleiner ist als eine für ein Überschreiten der Schaltschwelle erforderlicher Unterschied zwischen der Feldstärke eines durch das Maschinenelement in seiner nachzuweisenden Stellung hervorgerufenen Magnetfeldes am Ort des ersten und des zweiten Sensors. Mit anderen Worten, es war für eine zufriedenstellende Funktion dieses Näherungsschalters erforderlich, daß das Maschinenelement in seiner zu detektierenden Stellung am Ort des ersten Sensors ein größeres Feld erzeugt hat als am Ort des zweiten Sensors und daß diese Differenz stets größer war als die Differenz zwischen dem Störfeld am Ort des zweiten Sensors und dem Störfeld am Ort des ersten Sensors.

Diese Abhängigkeit des für eine einwandfreie Anzeige des Näherungsschalters notwendigen Magnetfeldes von dem Störfeld führt in vielen Anwendungsfällen zu Problemen, vor allem dann, wenn diese Störfelder betragsmäßig sehr groß werden und einen großen Gradient im Bereich der Sensoren aufweisen.

Die EP-A-0156696 offenbart einen Näherungsschalter, welcher in der Lage ist, die Relativposition eines zu messenden Elements zu einem Referenzelement zu erfassen. Dieser Näherungsschalter weist zwei induktive Näherungssensoren auf, die über Verstärkerglieder mit einem D-Flip-Flop gekoppelt sind, das jeweils erfaßt, welches Signal dem jeweils anderen Signal vorauseilt und somit die Relativposition der beiden Elemente ermittelt

Der Erfindung liegt, ausgehend von der DE-A-34 38 120, die Aufgabe zugrunde, einen Näherungsschalter der gattungsgemäßen Art derart zu verbessern, daß sowohl die Gradienten von dem durch das Maschinenelement erzeugten Nachweisfeld als auch die Gradienten des Störfeldes keinen Einfluß auf das Ansprechen des Näherungsschalters haben

Diese Aufgabe wird bei einem Näherungsschalter der eingangs beschriebenen Art erfindungsgemäß dadurch gelöst, daß das Umsetzen des Gesamtsignals in das Ausgangssignal dadurch erfolgt, daß die Zeitabhängigkeit des Störfeldes erfaßt wird, mit dem Zeitlichen Auftreten des Störfeldes synchronisierte Tastpulse erzeugt werden, und unter Heranziehung dieser Tastpulse das Gesamtsignal daraufhin abgetastet wird, ob es einen dem Störfeldsignalanteil überlagerten Signalanteil aufweist, wobei ein während der Abtastung ermittelter Wert nur dann zu einem das Maschinenelement in seiner nachzuweisenden Stellung anzeigenden Ausgangssignal führt, wenn dieser Wert einen vorwählbaren Mindestwert überschreitet, durch welchen eine für ein Ansprechen des Näherungsschalters erforderliche Mindestfeldstärkenänderung vorwählbar ist.

Aufgrund dieser Lösung kann das für ein Ansprechen des erfindungsgemäßen Näherungsschalters erforderliche Mindestmagnetfeld unabhängig von der Stärke oder auch dem Gradient des Störfeldes gewählt werden, da das Störfeld im Gegensatz zu den bisher bekannten Lösungen nicht durch eine Differenzbildung von an unterschiedlichen Orten gemessenen Störfeldstärken erfolgt, sondern dadurch, daß die Zeitabhängigkeit des Störfeldes ermittelt und dazu ausgenutzt wird, das Störfeld lediglich aufgrund seiner Zeitabhängigkeit zu eliminieren, so daß die Amplitude des Störfeldes als solche bei der Elimination desselben in erster Linie nicht relevant ist. Somit spielt es auch keine Rolle, wie groß die Absolutwerte des Störfeldes sind.

Bei der vorstehend beschriebenen erfindungsgemäßen Lösung wurde offengelassen, wie der erfindungsgemäße Schaltkreis ein Störfeldsignal erfaßt und daraus die Zeitabhängigkeit des Störfeldes ermittelt.

2

Hierfür sind mehrere unterschiedliche Möglichkeiten denkbar Eine erste Möglichkeit sieht vor, daß zum Erfassen der Zeitabhängigkeit des Störfeldes der Störfeldsignalanteil des Gesamtsignals herangezogen wird. Bei dieser ersten Möglichkeit ist somit ein einziger Sensor ausreichend, welcher das Gesamtsignal erzeugt, das den Störfeldsignalanteil umfaßt, so daß damit unmittelbar die Zeitabhängigkeit des Störfeldes ermittelt werden und die Tastpulsfolge generiert werden kann, mit welcher dann das Gesamtsignal als ganzes mit seinem Störfeldsignalanteil und seinem Nachweisfeldsignalanteil wiederum abgetastet wird.

Um dies zu erreichen, ist es nicht unbedingt notwendig, das Gesamtsignal zu zerlegen. Es wäre ebenfalls möglich, das Gesamtsignal beispielsweise mit einer Pulsfolge abzutasten und daraus die Zeitabhängigkeit zu ermitteln. Am einfachsten ist es jedoch, wenn der Störfeldsignalanteil aus dem Gesamtsignal ausgekoppelt und als zweites Signal dem Schaltkreis zur Erfassung der Zeitabhängigkeit des Störfeldes übermittelt wird, welcher daraus sogenannte zweite Pulse als Tastpulse generiert, mit welchen das als erstes Signal bezeichnete Gesamtsignal abgetastet wird.

Neben der vorstehend beschriebenen ersten Möglichkeit, die Zeitabhängigkeit des Störfeldes aus dem Gesamtsignal heraus zu ermitteln, ist eine zweite Möglichkeit vorteilhaft, bei welcher ein zweiter Sensor vorgesehen ist, welcher einen größeren Abstand von dem in einer zu detektierenden Stellung stehenden Maschinenelement aufweist als der erste Sensor und ein den Störfeldsignalanteil umfassendes zweites Signal generiert, und daß zum Erfassen der Zeitabhängigkeit des Störfeldes entweder aus dem vom ersten Sensor erzeugten ersten Signal oder aus dem vom zweiten Sensor erzeugten zweiten Signal die der Zeitabhängigkeit des Störfeldes entsprechende Folge von ersten Pulsen bzw. von zweiten Pulsen als Tastpulse gewonnen und mittels diesen Tastpulsen das zweite bzw. das erste Signal abgetastet wird. Bei der zweiten Möglichkeit sind also genau wie beim Stand der Technik zwei Sensoren vorgesehen, die beide ein den Störfeldsignalanteil umfassendes erstes bzw. zweites Signal generieren und von denen eines dazu verwendet wird, die Folge von Tastpulsen zu erzeugen, mit denen das jeweils andere Signal dann abgetastet wird. Durch Anwendung dieses Prinzips ist auch bei einem Näherungsschalter mit zwei Sensoren der Gradient des Störfeldes zwischen den beiden Orten der Sensoren unerheblich.

Um die der Zeitabhängigkeit des Störfeldes entsprechende Folge von Tastpulsen zu gewinnen, sind mehrere Möglichkeiten denkbar. Besonders einfach ist es, wenn bei den vorstehend beschriebenen Ausführungsformen die Tastpulse, d.h. entweder die ersten Pulse oder die zweiten Pulse zu jedem Zeitpunkt generiert werden, zu dem das erste Signal bzw. das zweite Signal einen Referenzwert durchläuft.

Bei allen vorstehend beschriebenen Möglichkeiten der erfindungsgemäßen Lösung kann ein Erfassen des abzutastenden Signals in vielerlei Art und Weise erfolgen. So ist es z.B. möglich, das abzutastende Signal dadurch zu erfassen, daß über einen Amplitudenwert dieses Signals während einer Pulsdauer integriert wird und das Integral dem ermittelten Wert entspricht. Eine derartige Abtastung ist insbesondere dann in einfacher Weise möglich, wenn die Pulse der Pulsfolge im Bereich von Null-Durchgängen des Störfeldes liegen ; da dann in dem Fall, in dem an beiden Sensoren lediglich das zeitabhängige Störfeld anliegt, die Integration über die Amplitude des abzutastenden Signals Null ergibt und nur dann, wenn irgendwelche Konstantanteile vorliegen, sich positive Signale ergeben. Weit vorteilhafter ist es jedoch, wenn zu jedem Zeitpunkt, zu dem das am ersten Sensor erzeugte erste Signal einen ersten Referenzwert durchläuft, ein erster Puls generiert wird und wenn zu jedem Zeitpunkt, zu dem das am zweiten Sensor erzeugte zweite Signal einen zweiten Referenzwert durchläuft, ein zweiter Puls generiert wird und wenn ein zeitlicher Abstand zwischen dem ersten und dem zweiten Puls dem ermittelten Wert entspricht, wobei der vorwählbare Mindestwert eine vorwählbare Mindestzeit darstellt. Bei dieser Ausfürhrungsform des erfindungsgemäßen Näherungsschalters werden nicht nur die Stöfeldanteile aufgrund ihrer Zeitabhängigkeit eliminiert, sondern es wird außerdem ein konstanter Feldanteil am ersten Sensor, hervorgerufen durch das Maschinenelement in seiner zu detektierenden Stellung, in eine ungefähr zu diesem Feldanteil proportionale zeitliche Verschiebung des ersten Pulses umgesetzt, so daß lediglich eine Zeitdifferenz zwischen dem ersten Puls und dem zweiten Puls gemessen werden muß, die mit den bekannten Methoden der Impulstechnik in einfacher Weise möglich ist, und folglich die gesamte weitere Signalverarbeitung mit digitaler Pulstechnick durchgeführt werden kann. Es ist hervorzuheben, daß somit die Feldstärken des zeitabhängigen Störfeldanteils ohne jeglichen Einfluß auf dem zeitlichen Abstand der Pulse sind, so daß bereits kleinen konstanten Feldanteilen am ersten Sensor entsprechende Verschiebungen des ersten Pulses, unabhängig von der Feldstärke des Störfeldes, nachweisbar sind und folglich auch eine einem zeitlichen Mindestabstand der Pulse entsprechende Schatschwelle des Näherungsschalters, unabhängig von den Feldstärken des Stöfeldes, wählbar ist und daher auch sehr niedrig Liegen kann.

Zur Messung des zeitlichen Abstsandes zwischen dem ersten Puls und dem zweiten Puls bestehen vielerlei Möglichkeiten. Mit bekannter Digitaltechnik ist eine einfache Ermittlung des zeitlichen Abstandes dann möglich, wenn zur Ermittlung des zeitlichen Abstandes mindestens ein Pulskoinzidenzen feststellendes Glied vorgesehen ist, da sich Pulskoinzidenzen in einfacher Weise mit NAND- oder NOR-Gattern festellen lassen.

Die Messung von Pulskoinzidenzen ist immer dann einfach, wenn die Pulse eine endliche Breite haben, so daß es vorteilhaft ist, wenn der erste Puls zeitlich verbreitert ist. Außerdem kann es auch vorteilhaft sein, wenn alternativ oder zusätzlich auch der zweite Puls zeitlich verbreitert ist.

Die Verbreiterung der Pulse kann durch eine Vielzahl möglicher Maßnahmen erfolgen, beispielsweise könnte es denkbar sein, eine Verbreiterung der Pulse durch spezielle Pulsformglieder herbeizuführen. Im vorliegenden Fall liegen jedoch bei der Erzeugung der Pulse zeitlich veränderliche Signale zugrunde, so daß die einfachste Möglichkeit einer Pulsverbreiterung darin besteht, daß diese durch beiderseits des jeweiligen Referenzwertes liegende Schwellwerte erfolgt, wobei ein Puls dann generiert wird, wenn das jeweilige Signal zwischen diesen Schwellwerten liegt. Mit einer derartigen Maßnahme können relativ aufwendige Pulsformglieder vermieden werden.

Besonders vorteilhaft kann es bei der Erzeugung einer Pulsverbreiterung sein, symmetrische Pulse zu erhalten, so daß die Schwellwerte symmetrisch zu dem jeweiligen Referenzwert liegen.

Bei den bischer beschriebenen Ausführungsbeispielen war nicht festgelegt, wie die jeweiligen Referenzwerte liegen sollen und somit auch nicht, an welcher Stelle der zeitabhängigen ersten und zweiten Signale die Generierung eines ersten oder zweiten Pulses erfolgen soll. Damit die Pulse in ihrer Breite bei einer Veränderung der Amplitude des jeweiligen Signals möglichst wenig verändert werden, ist es vorteilhaft, wenn der erste Puls im Bereich eines Null-Durchgangs des ersten Signals generiert wird. Das gleiche gilt für die Generierung des zweiten Pulses, so daß es ebenfalls vorteilhaft ist, wenn der zweite Puls im Bereich eines Null-Durchgangs des zweiten Signals generiert wird.

Für die Bestimmung des zeitlichen Abstandes zwischen dem ersten und dem zweiten Puls mittels des Pulskoinzidenzen feststellenden Gliedes sind für den Fachmann mehrere Variationen denkbar. Beispielsweise wäre es denkbar, mit dem zweiten Puls einen sogenannten Meßpuls zu triggern, dessen Koinzidenz mit dem ersten Puls in einfacher Weise festgestellt werden könnte. Um nun auch diesen Meßpuls nicht erzeugen zu müssen, sondern den zeitlichen Abstand direkt zwischen dem ersten und zweiten Puls ohne einen Zwischenpuls zu messen, wird vorgeschlagen, daß der zeitliche Abstand durch Feststellung einer Koinzidenz des verbreiterten ersten oder zweiten Pulses mit dem zweiten bzw. ersten Puls ermittelt wird. Das heißt also, daß einer der Pulse verbreitert wird, so daß solange eine Koinzidenz zwischen dem ersten und dem zweiten Puls festgestellt wird, bis diese zeitlich so weit gegeneinander verschoben sind, daß der zeitlich verbreiterte Puls nicht mehr mit dem anderen Puls zusammenfällt. Dies stellt eine einfache Möglichkeit dar, über die Verbreiterung eines der Pulse eine vorwählbare Mindestzeit einzustellen, so daß das Überschreiten der Mindestzeit immer dann gegeben ist, wenn eine Koinzidenz zwischen dem verbreiterten Puls und dem anderen Puls nicht mehr vorliegt. Die Mindestzeit entspricht somit ungefähr der halben Pulbreite des verbreiterten Pulses, wobei dann der andere Puls eine zu vernachlässigende zeitliche Breite haben muß.

Desgleichen ist es auch möglich, mit zwei verbreiterten Pulsen zu arbeiten, so daß der zeitliche Abstand durch Feststellung einer Koinzidenz der verbreiterten ersten mit dem verbreiterten zweiten Pulsen ermittelt wird.

Im Rahmen des vorstehenden Ausführungsbeispiels hat es sich als besonders vorteilhaft erwiesen, wenn der erste Puls um ungefähr einen Faktor vier breiter ist als der zweite Puls.

Zur Feststellung der Koinzidenz des ersten und des zweiten Pulses sind ebenfalls mehrere Logikmöglichkeiten denkbar. Ganz besonders vorteilhaft für einen erfindungsgemässen Näherungsschalter ist es, wenn als Pulskoinzidenzen feststellendes Glied ein statisch getaktetes D-Flip-Flop mit folgender Wahrheitstafel

| D | T | Q |
|---|---|---|
| 0 | 0 | 1 |
| 1 | 0 | 0 |
| 0 | 1 | } vor dem Übergang |
| 1 | 1 | } von T = 0 nach |
|   |   | } T = 1 anliegender |
|   |   | D-Wert invertiert |

D ) Eingänge des
T ) D-Flip-Flops

Q = invertierter Ausgang des D-Flip-Flops

verwendet wird.

Dieses Flip-Flop hat die vorteilhafte Eingenschaft, bei einem Übergang von T = 0 nach T = 1 den vorher anliegenden Wert zu halten, so dass, sobald sich der erste und der zweite Puls nicht mehr vollständig überlappen, zumindest über bestimmte Zeiträume ein von Null unterschiedliches Ausgangssignal vorliegt.

Ein derart teilweise sich änderndes Signal ist als Ausgangssignal für einen Näherungsschalter nicht geeignet, denn dieser muß dann, wenn das Maschinenelement in seiner zu detektierenden Stellung steht, stets dasselbe Ausgangssignal zeigen. Das gleiche gilt für den Fall, in welchem das Maschinenelement nicht in sei-

EP 0 283 487 B1

ner zu detektierenden Stellung steht. Aus diesem Grund ist vorgesehen, daß auf einem Ausgang des Pulskoinzidenzen feststellendes Gliedes folgend ein Halteglied vorgesehen ist. Dieses Halteglied sorgt dafür, daß der Näherungsschalter stets ein konstantes Ausgangssignal abgibt.

Da bei teilweiser Überlappung des ersten und zweiten Pulses das Ausgangssignal des statisch getakteten D-Flip-Flops über einen Zeitraum, welcher ungefähr einer halben Periodendauer des Störfeldes entspricht, abfallen kann, ist vorgesehen, daß das Halteglied ein Ausgangssignal des Pulskoinzidenzen feststellendes Gliedes über mindestens eine halbe Periodendauer des Störfeldes hält, so daß in jedem Fall ein konstantes Ausgangssignal vorliegt.

Die einfachste Ausführungsform eines Haltegliedes sieht vor, daß das Halteglied ein R-C-Glied ist.

In besonderen Fällen kann ein zu großer Gradient des Störfeldes über dem Abstand der beiden Sensoren zueinander dazu führen, daß der erfindungsgemäße Näherungsschalter, obwohl das Maschinenelement nicht in seiner zu detektierenden Stellung steht, ein Ausgangssignal abgibt, welches das Maschinenelement in seiner zu detektierenden Stellung anzeigt. Dies ist dann der Fall, wenn die Breite des zweiten Pulses gleich groß ist wie die des ersten Pulses oder diesen übersteigt. Diese Fälle können dadurch vermieden werden, daß der erste Sensor in einem der Gleichung

$$r = \frac{d}{k-1}$$

r = Mindestabstand des ersten Sensors von einer Quelle des Störfeldes

d = Sensorabstand

k = Verhältnis der Breite des ersten zur Breite des zweiten Pulses

entsprechenden Mindestabstand von einer Quelle des Störfeldes angeordnet ist. Damit ist sichergestellt, daß der Gradient des Störfeldes nur so groß ist, daß der vorstehend beschriebene Fall nicht eintritt. Die angegebene Gleichung demonstriert wiederum in eindrucksvoller Weise, daß die Feldstärke des Störfeldes auf die Funktion des erfindungsgemäßen Näherungsschalters keinen Einfluß hat.

Die in der Regel verwendeten Sensoren für die Messung von Feldern sind so aufgebaut, daß sie hinsichtlich einer Feldmessung eine Vorzugsrichtung aufweisen. Diese Vorzugsrichtung wurde bei den bisher beschriebenen Ausführungsbeispielen nicht festgelegt und konnte somit bei beiden Sensoren beliebig orientiert sein. Un universell einsetzbare Sensoren herzustellen, die keine allzu große oder nur eine gemeinsame definierte Richtungsabhängigkeit für ein zu messendes Feld aufweisen, ist es vorteilhaft, daß die Sensoren eine Vorzugsrichtung aufweisen und so angeordnet sind, daß sie Vorzugsrichtungen parallel zueinander stehen.

Bei den bisher erläuterten Ausführungsbeispielen wurde stets offengelassen, ob die Sensoren zum Nachweis elektrischer, magnetischer oder elektromagnetischer Felder geeignet sein sollen. Es ist denkbar, einen erfindungsgemäßen Näherungsschalter aufzubauen, welcher für jeweils eine der genannten Anwendungsmöglichkeiten geeignet ist. In der Regel arbeiten die bisher bekannten Näherungsschalter jedoch nach dem Prinzip, daß entweder das Maschinenelement selbst ein Magnetfeld erzeugt oder daß das Maschinenelement ein Magnetfeld deformiert. Aus diesem Grund ist es vorteilhaft, wenn die Sensoren Magnetfeldsensoren sind.

Vor allem in all den Fällen, in denen es nicht möglich ist, in dem Maschinenelement selbst einen Magneten anzuordnen, das Maschinenelement jedoch aus einem Material besteht, das geeignet ist, ein Magnetfeld zu deformieren, ist es erforderlich, daß dem ersten Sensor ein Permanentmagnet zugeordnet ist, welcher mit seinem Magnetfeld den ersten Sensor in Richtung seiner Vorzugsrichtung durchflutet. Bei einer solchen Ausführungsform des erfindungsgemäßen Näherungsschalters führt die Deformation des Magnetfeldes des Permanentmagneten dazu, daß sich die Durchflutung des ersten Sensors und somit auch dessen konstanter, durch den Permanentmagneten hervorgerufener Signalanteil immer dann geändert wird, wenn das Maschinenelement in seiner zu detektierenden Stellung steht.

Ganz besonders vorteilhaft ist es, wenn die Anordnung so getroffen ist, daß der Permanentmagnet mit einem Nord- oder einem Südpol dem ersten Sensor zugewandt angeordnet ist, da in diesen Fällen der Sensor von einer hohen Flußdichte durchsetzt ist.

Bei all diesen Anwendungen eines Permanentmagneten im Bereich des ersten Sensors ist jedoch bei der Anordnung des ersten Referenzwertes zu berücksichtigen, daß auch dann, wenn das Maschinenelement nicht in seiner zu detektierenden Stellung steht, das erste Signal einen konstanten Anteil aufgrund der ständigen Durchflutung des ersten Sensors aufweist. In diesem Fall ist nur dann ein Nachweis des Maschinenelements in seiner zu detektierenden Stellung in einfacher Weise möglich, wenn der erste Referenzwert einem ersten Signal bei Abwesenheit des Störfeldes und Abwesenheit des Maschinenelements in seiner zu detektierenden

5

Stellung entspricht.

Ein besonders vorteilhafte Anordnung des Permanentmagneten relativ zu den Sensoren und zu dem Maschinenelement liegt dann vor, wenn die Sensoren so angeordnet sind, daß deren Vorzugsrichtungen in Richtung einer Verbindungslinie der Sensoren weisen und daß der Permanentmagnet auf einer dem Maschinenelement in seiner zu detektierenden Stellung abgewandten Seite des ersten Sensors angeordnet ist. In diesem Fall führt das Maschinenelement in seiner zu detektierenden Stellung dazu, daß der erste Sensor stärker durchflutet ist als bei Abwesenheit des Maschinenelements von seiner zu detektierenden Stellung. Eine weitere vorteilhafte Anordnung sieht vor, daß die Sensoren so angeordnet sind, daß ihre Vorzugsrichtungen ungefähr senkrecht auf einer Verbindungslinie der Sensoren stehen, wobei, wie bereits erläutert, in einem solchen Fall der Permanentmagnet auf einer Seite des ersten Sensors liegen soll. In diesen Fällen führt das Maschinenelement in seiner zu detektierenden Stellung zu einer Verzerrung des Magnetfeldes in der Weise, daß die Durchflutung des Sensors relativ zu dem Fall abnimmt, in dem das Maschinenelement nicht in seiner zu detektierenden Stellung steht.

Zum Nachweis von Magnetfeldern ist es besonders günstig, wenn der erste und der zweite Sensor Hallsensoren sind, da diese gegen magnetische Übersteuerungen geschützt sind und somit auch bei sehr hohen Störfeldern bis zu 600 kA/m nicht beschädigt werden können.

Es ist aber auch möglich, daß die Sensoren magnetoresistive Sensoren sind, wobei sich insbesondere Permalloy-Sensoren als geeignete Sensoren anbieten.

Sämtliche der genannten Sensoren werden jedoch bei ihrem Einsatz in allen Ausführungsbeispielen der erfindungsgemäßen Näherungsschalter nicht in dem ganzen möglichen Feldbereich eingesetzt, sondern in der Regel nur in einem Bereich, der ungefähr 10% des ausnutzbaren Feldstärkebereichs dieser Sensoren umfaßt. Aus diesem Grund wirken sich Temperaturdriften, insbesondere der Null-Linie, d.h. des Offsets, der Sensoren sehr stark dahingehend aus, daß die Pulse zeitlichen Schwankungen unterworfen sind und daher die als Schaltschwelle vorgewählte Mindestzeit lediglich aufgrund dieser Temperaturdriften überschritten werden kann. Eine vorteilhafte Möglichkeit, solche Temperaturdriften zu unterdrücken, d.h. ihren prozentualen Anteil geringer zu machen, besteht darin, daß auf einer aktiven Fläche von mindestens einem der Sensoren ein Material mit einer Suszeptibilität von $\mu > 1$ angeordnet ist. Dieses Material hat die Eigenschaft, die magnetischen Feldlinien zu bündeln und somit eine verstärkte magnetische Durchflutung der Sensoren in ihrer Vorzugsrichtung herbeizuführen, so daß diese zum Nachweis der Magnetfelder in einem größeren Feldstärkebereich ausgenutzt werden, so daß folglich auch die ersten und/oder zweiten Signale größer werden und damit die Drift der Null-Linie zu einer geringeren zeitlichen Verschiebung der ersten und/oder zweiten Pulse führt. Dies ist dadurch bedingt, daß das erste oder zweite Signal die Referenz- oder Schwellwerte mit größerer Steigung schneiden und somit ergibt dieselbe Nullpunktsschwankung eine kleinere zeitliche Schwankung der Pulse.

Weitere Vorteile und Eingenschaften des erfindungsgemäßen Näherungsschalters ergeben sich aus der folgenden Beschreibung sowie der zeichnerischen Darstellung einiger Ausführungsbeispiele. In der Zeichnung zeigen :

Fig. 1 eine perspektivische, teilweise aufgebrochene Darstellung eines ersten Ausführungsbeispiels eines erfindungsgemäßen Näherungsschalters ;

Fig. 2 ein Blockdiagramm einer Funktionsweise des ersten Ausführungsbeispiels ;

Fig. 3 eine schematische Darstellung einer Zeitabhängigkeit von in Fig. 2 auftretender Signale ;

Fig. 4 eine Schaltungsskizze des ersten Ausführungsbeispiels ;

Fig. 5 ein zweites Ausführungsbeispiel des erfindungsgemäßen Näherungsschalters ;

Fig. 6 ein drittes Ausführungsbeispiel des erfindungsgemäßen Näherungsschalters ;

Fig. 7 ein viertes Ausführungsbeispiel des erfindungsgemäßen Näherungsschalters ;

Fig. 8 ein Ausführungsbeispiel eines Sensors aus maneoresistiven Sensoren ;

Fig. 9 ein fünftes Ausführungsbeispiel des erfindungsgemäßen Näherungsschalters und

Fig. 10 eine Schaltungsskizze des fünften Ausführungsbeispiels.

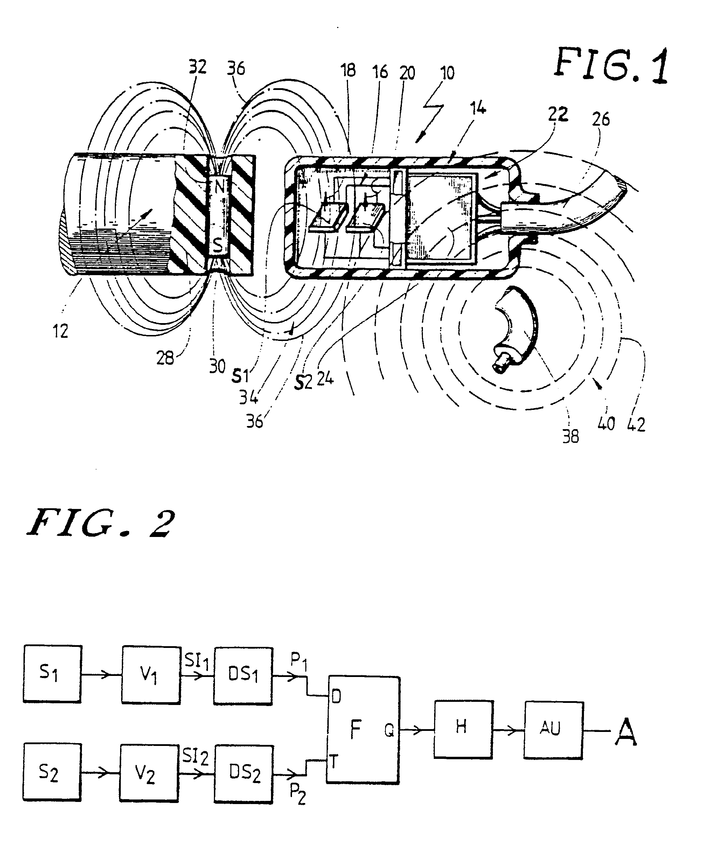

Eines erstes Ausführungsbeispiel des erfindungsgemässen Näherungsschalters, in Figur 1 als Ganzes mit 10 bezeichnet, zum Nachweis eines Maschinenelements 12 in seiner jeweiligen nachzuweisenden Stellung umfasst ein Gehäuse 14, in welchem in einem dem Maschinenelement 12 zugewandten Gehäuseteil 16 zwei Sensoren S1 und S2 so im Abstand voneinander angeordnet sind, dass der Sensor S1 näher bei dem Maschinenelement 12 in seiner nachzuweisenden Stellung liegt als der Sensor S2. Die beiden Sensoren S1 und S2 haben jeweils durch Pfeile gekennzeichnete Vorzugsrichtungen 18 und 20 und werden bevorzugterweise so angeornet, dass die Vorzugsrichtungen 18 und 20 parallel zueinander liegen. In einem dem Maschinenelement 12 abgewandten Gehäuseteil 22 ist eine als Ganzes mit 24 bezeichnete Schaltung angeordnet, mittels welcher ein Ausgangssignal A des Näherungsschalters erzeugt wird. Eine Spannungsversorgung des erfindungsgemässen Näherungsschalters 10 erfolgt über ein in den Gehäuseteil 22 mündendes Zuleitungskabel 26, welches auch eine Leitung zur Übertragung des Ausgangssignals A umfasst.

Das Maschinenelement 12 ist in einem dem Näherungsschalter zugewandten Bereich 28 mit einer sich durch diesen Bereich 28 erstreckenden Bohrung 30 versehen, in welcher ein Magnet 32 aufgenommen ist. Das von einem Nord- und einem Südpol des Stabmagneten 32 ausgehende Magnetfeld 34 durchsetzt mit seinen Feldlinien 36 zumindest den Gehäuseteil 16 des Näherungsschalters 10 und somit auch die beiden Sensoren S1 und S2.

Die parallel zueinander ausgerichteten Vorzugsrichtungen 18 und 20 sind bevorzugterweise so ausgerichtet, daß sie parallel zu den die Sensoren S1 und S2 durchdringenden Feldlinien 36 des Magnetfelds 34 verlaufen.

Eine in der Umgebung des Näherungsschalters 10 verlaufende Stromleitung 38 oder eine Schweißelektrode, welche einen hohen Strom, beispielsweise für Schweißvorgänge und ähnliche hohe Ströme benötigende Einrichtungen führt, erzeugt ein Störfeld 40, dessen Störfeldlinien 42 im wesentlichen in radialer Richtung um die Stromleitung 38 verlaufen und ebenfalls den gesamten Näherungsschalter 10 und somit auch die Sensoren S1 und S2 – im ungünstigsten Fall parallel zu den Vorzugsrichtungen 18, 20 – durchsetzen.

Somit durchdringen sowohl die Feldlinien 36 des Magnetfelds 34 als auch die Störfeldlinien 42 des Störfelds 40 die Sensoren S1 und S2. Erfindungsgemäß wird jedoch der Abstand zwischen den Sensoren S1 und S2 so gewählt, daß das mit zunehmendem Abstand von dem Magnet 32 sehr stark abfallende Magnetfeld 34 im Bereich des Sensors S2 nur zu einem unwesentlichen Beitrag führt und somit in der Regel beim Sensor S2 vernachlässigt werden kann. Dagegen ist das Störfeld aufgrund der hohen Ströme in der Stromleitung 38 in der Regel so stark, daß es beide Sensoren S1 und S2 durchsetzt, wobei die Feldstärke am Ort der Sensoren S1 und S2 davon abhängt, wie die Stromleitung 38 relativ zu den Sensoren S1 und S2 angeordnet ist.

Bei der in Fig. 1 zeichnerisch dargestellten Anordnung ist die Feldstärke des Störfeldes 40 am Ort des Sensors S2 größer als am Ort des Sensors S1.

Ein genereller Unterschied zwischen dem Störfeld 40 und dem Magnetfeld 34 ist darin zu sehen, daß die über die Stromleitung 38 betriebenen Aggregate in der Regel mit Wechselstrom gespeist werden, so daß das Störfeld 40 entsprechend der Frequenz des Wechselstroms zeitabhängig ist, wohingegen es sich bei dem Magnetfeld 34 stets um ein konstantes, zeitlich nicht veränderbares Feld handelt.

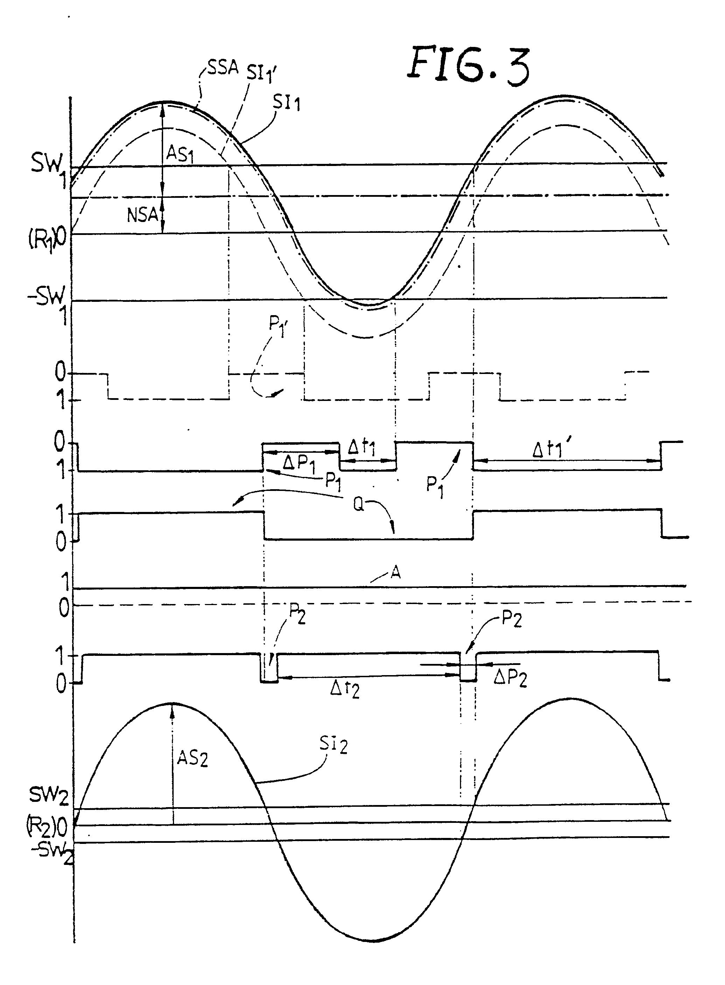

Die Schaltung 24 arbeitet nach dem in Fig. 2 dargestellten Blockschaltbild, dessen Funktionen aus der Darstellung der dabei erzeugten Signale und Pulsfolgen in Fig. 3 zusätzlich erläutert wird.

Der von dem Magnetfeld 34 und dem Störfeld 40 durchflutete Sensor S1 erzeugt ein durch den Verstärker V1 verstärktes Signal SI1, das – wie in Fig. 3 dargestellt – aus einem von dem Störfeld 40 herrührenden oszillierenden Störfeldsignalanteil SSA mit einer Amplitude AS1 und einem von dem Magnetfeld 34 herrührenden konstanten Nachweisfeldsignalanteil NSA zusammengesetzt ist und somit insgesamt ein gegenüber einer Null-Linie verschobenes oszillierendes Signal darstellt. Das Signal SI1 wird einem Diskriminator DS1 zugeführt, welcher ermittelt, ob die Amplitude des zeitabhängigen Signals SI1 zwischen zwei symmetrisch zu einem Referenzwert R und im vorliegenden Fall auch zur Null-Linie liegenden Schaltschwellen SW1 und –SW1 liegt oder nicht. Wenn die Amplitude des Signals SI1 größer ist als die Schaltschwelle SW1 und –SW1, gibt der Diskriminator DS1 an seinem Ausgang ein Signal NULL ab, wenn die Amplitude des Signals SI1 kleiner ist als die Schaltschwellen SW1 und –SW1, d.h. also zwischen diesen beiden liegt, dann gibt der Diskriminator an seinem Ausgang ein Signal EINS ab. Somit führt jeder Nulldurchgang der Amplitude des Signals SI1 zu einem Anstieg auf EINS des ansonsten an dem Ausgang des Diskriminators DS1 anliegenden Signals NULL und somit durch den Anstieg auf EINS zu einem auch als Puls P1 zu bezeichnenden Signal, wobei die zeitliche Breite ΔP1 des Pulses P1 davon abhängt, wie die Schaltschwellen SW1 und –SW1 relativ zur Null-Linie liegen. Liegen die Schaltschwellen SW1 und –SW1 weit von der Null-Linie entfernt, d.h. sind sie sehr hoch, so ist auch die zeitliche Breite ΔP1 des Pulses P1 sehr groß, während bei niedrig und dicht bei der Null-Linie liegenden Schaltschwellen SW1 und –SW1 die zeitliche Breite ΔP1 des Pulses P1 klein ist.

Wenn das Signal SI1 um den Nachweisfeldsignalanteil NSA in positiver Richtung gegenüber der Null-Linie verschoben ist, erfolgen auch die Nulldurchgänge der Amplitude des Signals SI1 nicht in gleichen Zeitabständen, sondern es folgen jeweils zwei Pulse P1 in einem kurzen Zeitabstand ΔT1, während der darauffolgende Puls P1 nach einem längeren Zeitabstand ΔT1' folgt. Selbstverständlich kann das Signal SI1 auch um den Anteil NSA in negativer Richtung verschoben sein.

Für die Beschreibung des vorliegenden Ausfüjrungsbeispiels sei angenommen, daß der Sensor S2 lediglich von dem Störfeld 40 durchflutet ist. Somit erzeugt das Störfeld 40 in dem Sensor S2 ein durch einen Verstärker V2 verstärktes Signal SI2, welches, wie bereits erläutert, aufgrund des in der Stromleitung 38 fließenden Wechselstroms ebenfalls die gleiche Zeitabhängigkeit wie das Signal SI1 aufweist, jedoch lediglich einen Amplitudenanteil AS2 des Wechselfeldes zeigt und somit symmetrisch zu einer Null-Linie verläuft. Dieses Signal SI2 wird einem in gleicher Weise wie der Diskriminator DS1 funktionierenden Diskriminator DS2 zugeführt, welcher zwei symmetrisch zu einem Referenzwert R2 und im vorliegenden Fall auch zur Null-Linie liegende Schaltschwellen SW2 und –SW2 aufweist. Je nachdem ob die Amplitude AS2 des Signals SI2 zwischen

7

EP 0 283 487 B1

den Schaltschwellen SW2 und –SW2 liegt oder nicht, wird ein Ausgangssignal 1 des Diskriminators DS2 auf Null herabgesetzt oder nicht. Somit führt jeder Nulldurchgang der Amplitude AS2 in dem Diskriminator DS2 zu einem von dem Wert 1 auf den Wert Null sich ändernden Puls P2 mit einer zeitlichen Breite $\Delta$P2, die ebenfalls von der Lage der symmetrisch zur Null-Linie liegenden Schaltschwellen SW2 und –SW2 abhängt, d.h. bei niedrig liegenden Schaltschwellen SW2 und –SW2 wird auch die zeitliche Breite $\Delta$P2 der Pulse P2 geringer, während sie bei weiter auseinanderliegenden Schaltschwellen SW2 und –SW2 größer wird.

Da das Signal SI2 symmetrisch zur Null-Linie, sind auch die zeitlichen Abstände $\Delta$T2 zwischen den aufeinanderfolgenden Pulsen P2 gleich groß, sie ändern sich jedoch immer dann, wenn auch das Signal SI2 einen Konstantanteil aufweist. Die Pulse P2 dienen im Sinne der vorliegenden Erfindung als Tastpulse P, mit welchen das erste Signal SI1 abgetastet wird, wobei bei dem beschriebenen Ausführungsbeispiel auch dieses Abtasten des ersten Signals SI1 durch Pulstechnik, d.h. durch Vergleich des in der beschriebenen Weise ebenfalls in Pulse P1 umgewandelten Signals Si1 mit den Pulsen P2, erfolgt.

Zu diesem Vergleich der Pulse P2 und P1 wird der Puls P1 einem Eingang D eines statisch getakteten D-Flip-Flops F zugeführt und der Puls P2 dem Eingang T deises Flip-Flops. Ein statisch getaktetes D-Flip-Flop hat die Eigenschaft, eine logische Variable D in Abhängigkeit des Eingangs T zu speichern, so daß ein invertierter Ausgang Q des statisch getakteten D-Flip-Flops entsprechend folgender Wahrheitstafel gesteuert wird.

```
        Wahrheitstafel des statisch getakteten
                      D-Flip-Flops


              D           T           Q
        ────────────────────────────────────────

              O           O           1
              1           O           O
              O           1       ⎫   vor Änderung von
              1           1       ⎬   T=O→T=1 anliegender
                                  ⎭   Wert von D
```

Diese Wahrheitstafel zeigt, daß der Ausgang Q des statisch getakteten D-Flip-Flops F jeweils dann die invertierten Werte vom Eingang D zeigt, wenn T = 0 ist, und daß am Ausgang Q bei T = 1 immer die Werte vorliegen, die vor einem Übergang von T = 0 nach T = 1 am Eingang D anlagen.

Wie am besten aus Fig. 3 zu erkennen ist, wird der Ausgang Q immer dann über eine Periodendauer des Störfeldes gesehen zeitweilig Null, wenn sich die Pulse P1 und P2 gegenseitig teilweise überlappen. Ist beispielsweise jedoch der stationäre Anteil NSA des Signals SI1 so gross, dass der zeitliche Abstand $\Delta$T1 aufeinanderfolgender Pulse P1 so klein ist, dass diese zwischen zwei Pulsen P2 in dem Zeitintervall $\Delta$T2 liegen, so ist das Ausgangssignal Q stets 1. Ferner ist das Signal Q stets dann Null, wenn sich die Pulse P1 und P2 vollständig überlappen, d.h. die Pulse P2 mit ihrer Pulsbreite $\Delta$P2 innerhalb der Pulse P1 mit ihrer Pulsbreite $\Delta$P1 liegen, was immer dann der Fall ist, wenn der stationäre Anteil BS am Signal SI1 Null ist, d.h. wenn der Sensor S1 nicht von einem statischen Magnetfeld durchflutet ist.

Aus letzterem ist bereits zu erkennen, dass er vorteilhaft ist, die Breite $\Delta$P1 des Pulses P1 stets grösser als die Breite $\Delta$P2 des Pulses P2 zu wählen, da in einem solchen Fall stets gewährleistet ist, dass der Näherungsschalter nicht aufgrund irgendwelcher geringen Schwankungen eines statischen Magnetfeldes das Maschinenelement 12 in seiner nachzuweisenden Stellung anzeigt und folglich ein sicheres Halten der Anzeige "kein Maschinenelement in seiner nachzuweisenden Stellung" sichergestellt ist.

Bei dem vorliegenden Ausführungsbeispiel wurde die Breite $\Delta$P1 so gewählt, dass sie ungefähr viermal so gross ist wie die Breite $\Delta$P2, was übertragen auf die Schwellwerte SW1 und SW2 in erster Näherung zur Folge hat, dass die Schwellwerte SW1 ungefähr viermal höher liegen als die Schwellwerte SW2. Dies gilt jedoch nur für den Fall, dass die Amplituden des Störfeldes 40 am Ort der beiden Sensoren S1 und S2 ungefähr gleich gross sind. Wird die Amplitude des Störfeldes grösser, so führt dies zu einer relativen Verschmälerung der zeitlichen Breite der Pulse $\Delta$P1 oder $\Delta$P2.

Wie bereits dargelegt, wechselt immer dann, wenn sich die Pulse P1 und P2 teilweise überlappen, das Ausgangs- signal Q des statisch getakteten D-Flip-Flops F zwischen Null und 1. In diesem Zustand liegt jedoch

8

bereits eihe Verschiebung der Pulse P1 relativ zu den Pulsen P2 aufgrund des konstaten Anteils BS beim Signal SI1 vor, so dass bereits dieser Zustand eine Annäherung des Maschinenelements 12 an seinen nachzuweisenden Zustand an den Näherungsschalter angibt. Folglich sollte auch das Ausgangssignal A des Näherungsschalters keinen zeitlichen Schwankungen unterworfen sein, sondern jeweils ein konstantes, das Maschinenelement 12 in seiner nachzuweisenden Stellung angebendes Signal zeigen. Aus diesem Grund ist dem statisch getakteten D-Flip-Flop F ein Impulshalteglied H nachgeordnet, welches den Zustand 1 am Ausgang Q des Flip-Flops F mindestens über eine halbe Periode des zeitabhängigen Störfeldes hält und somit an seinem Ausgang einer auf dieses Impulshalteglied folgenden Ausgangsstuffe AS stets ein von Null verschiedenes Signal zur Verfügung steht, so dass die Ausgangsstufe AS ihrerseits das erforderliche, das Maschinenelement 12 in seiner nachzuweisenden Stellung anzeigende Ausgangssignal A liefert.

Abweichend von dem bisher beschriebenen Fall, in welchem davon ausgegangen wurde, dass der Sensor S1 sowohl von dem Magnetfeld 34 als auch von dem Störfeld 40 durchsetzt ist, ist in dem Fall, in dem das Maschinenelement 12 nicht in seiner nachzuweisenden Stellung steht, der Sensor S1 ebenfalls lediglich von dem Störfeld 40 durchstezt, so dass ein Signal SI1' dem Diskriminator DS1 zugeführt wird, welches lediglich den oszillierenden Amplitudenanteil AS1 aufweist. In diesem Fall ist das Signal SI1' symmetrisch zur Nullinie, so dass infolgedessen auch die Nulldurchgänge und somit auch die Pulse P1' stets nach denselben Zeitintervallen auftreten. Eine dem jeweiligen Nulldurchgang der Amplitude AS1 entsprechende Pulsmitte des Pulses P1' liegt somit zeitgleich mit einer dem Nulldurchgang der Amplitude AS2 entsprechende Pulsmitte des Pulses P2, so dass sich insgesamt die Pulse P1' und P2 vollständig überlappen. Wie bereits ausgeführt, wird die Pulsbreite $\Delta$P1' in der Regel ungefähr viermal so gross gewählt wie die Pulsbreite $\Delta$P2, so dass das D-Flip-Flop F an seinem Ausgang Q stets den Wert Null anzeigt.

Der erfindungsgemässe Näherungsschalter funktioniert nun folgendermassen :

Ausgehend vom letztbeschriebenen Zustand, bei welchem der Ausgang Q des Flip-Flops F stets Null anzeigt, liegt auch am Ausgang A des Näherungsschalters der Wert Null vor, welcher dem Zustand entspricht, bei dem das Maschinenelement 12 nicht in seiner nachzuweisenden Stellung steht. Eine Annäherung des Maschinenelements 12 an den Näherungsschalter 10 hat zur Folge, dass der Sensor S1 in zunehmendem Maße von dem Magnetfeld 34 durchflutet wird und somit der Anteil BS des Signals SI1 stetig ansteigt und folglich das Signal SI1 asymmetrisch zur Nullinie wird. Damit verschieben sich auch die Nulldurchgänge der Amplitude des Signals SI1 und infolgedessen auch die Pulse P1 im Vergleich mit dem Puls P1', die einem lediglich mit dem Störfeld 40 durchsetzten Sensor S1 entsprechen. Die mit steigendem Anteil BS zunehmende Verschiebung der Pulse P1 relativ zu den Pulsen P1' und somit auch relativ zu den Impulsen P2 führt zunächst so lange nicht zu einer Änderung des Ausgangssignals, so lange die Impulse P2 noch vollständig mit den Pulsen P1 überlappen. In dem Moment, in dem jedoch eine von 0 nach 1 gehende seitliche Flanke der Pulse P1 innerhalb eines der Pulse P2 zu liegen kommt, führt dies am Ausgang des D-Flip-Flops F dazu, daß dessen Ausgang Q dann den Zustand 0 annimmt, wenn vor einem Ende eines Pulses P2 der Puls P1 angestiegen ist, d.h. sich auf den Wert 1 verändert hat, da nämlich dann bei Änderung am Eingang T von Null nach 1 der zuletzt anliegende, d.h. somit der Wert 1 am Eingang D am Ausgang Q als 0 gehalten wird. Das Signal am Ausgang Q entspricht dem in Figur 3 dargestellten Signal Q.

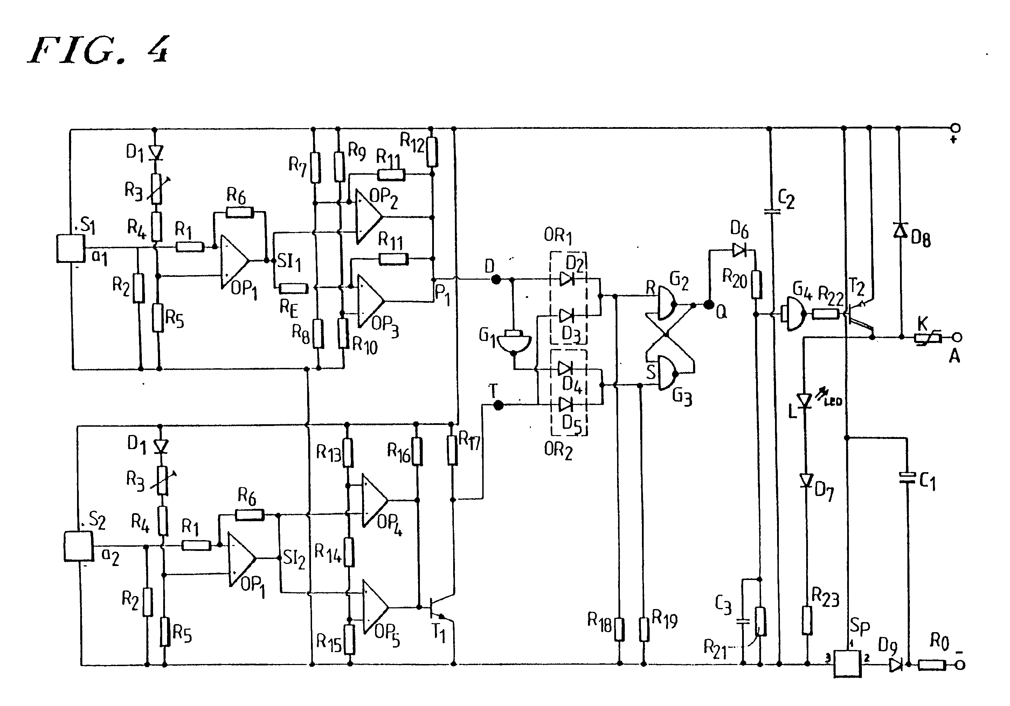

In diesem Fall kommt, wie bereits erwähnt, das Impulshalteglied H zum Tragen, das dafür sorgt, dass das in einzelnen Intervallen auf Null abfallende Signal Q nicht in dieser Form am Ausgang anliegt, sondern dass der Wert 1 des Signals Q mindestens über eine halbe Periode des zeitlich oszillierenden Störfeldes gehalten wird und somit ständing am Ausgang A einer Ausgangsstufe AU ein von Null abweichendes und das Maschinenelement 12 in seiner nachzuweisenden Stellung anzeigendes Signal anliegt. Die dem Blockdiagramm in Figur 2 entsprechende Schaltung in Fig. 4 zeigt im einzelnen eine positive Spannungsversorgung (+) sowie eine negative Spannungsversorgung (–), wobei um eine möglichst konstante Spannung zur Verfügung zu stellen, ein Spannungsregler SP vorgesehen ist, welcher mit einem Eingang 1 an der Spannungsversorgung (+) und mit einem Eingang 2 über eine Diode D9 und einen Widerstand R0 mit der negativen Spannungsversorgung in Verbindung steht und an seinem Ausgang 3 eine geregelte negative Spannung für die Schaltung verfügbar hält. Zur Glättung und Störunterdrückung der zu regelnden Spannung ist zwischen dem Eingang 1 des Spannungsreglers SP sowie einem Abgriff zwischen der Diode D9 und dem Widerstand R0 ein Kondensator C1 vorgesehen. Die am Ausgang 3 des Spannungsreglers SP zur Verfügung gestellte geregelte Spannung wird außerdem noch durch einen Kondensator C2 geglättet. Der erfindungsgemäßen Schaltung steht somit eine positive Speisespannung (+) und eine negative Speisespannung (–) zur Verfügung.

Der Sensor S1 ist sowohl an die positive Speisespannung (+) als auch an die negative Speisespannung (–) angeschlossen und wird durch diese versorgt. Entsprechend dem den Sensor S1 durchflutenden Magnetfeld liegt ein Ausgang a1 des Sensors S1 auf einem durch das Magnetfeld veränderlichen Potential. Der Ausgang a1 des Sensors S1 ist über einen Widerstand R1 mit einem invertierenden Eingang eines Operationsverstärkers OP1 verbunden. Des weiteren liegt zwischen a1 und R1 sowie der negativen Speisespannung noch ein Widerstand R2. Ein nicht invertierender Eingang des Operationsverstärkers OP1 liegt auf einem Potential, welches durch einen Spannungsteiler umfassend einerseits eine an die positive Speisespannung (+) angeschlossene Diode D1 mit einer dem selektierten Sensor 1 entsprechenden Temperaturdrift, auf diese folgend einen regelbaren Widerstand R3 zum Einstellen eines Offset und zusätzlich zu diesem in Reihe geschaltet einen konstanten Widerstand R4 und andererseits einen mit der negativen Speisespannung (–) verbundenen Widerstand R5. Ein Ausgang des Operationsverstärkers OP1 ist zur Rückkopplung noch über einen Widerstand R6 mit dem invertierenden Eingang des Operationsverstärkers OP1 verbunden. Durch diese Verstärkerschaltung liegt das Signal a1 des Sensors S1 am Ausgang des Operationsverstärkers OP1 als verstärktes Signal SI1 an.

Der Sensor S2 wird ebenfalls durch die positive Speisespannung (+) und die negative Speisespannung (–) versorgt, so dass an einem Ausgang a2 des Sensors S2 ebenfalls ein dem den Sensor S2 durchflutenden Magnetfeld entsprechendes Signal a2 anliegt. Dieses Signal a2 wird durch eine mit der vorstehend beschriebenen Verstärkerschaltung identische Verstärkerschaltung, deren Bauteile mit denselben Bezugszeichen versehen sind, zu einem Signal SI2 verstärkt.

Wie bereits in dem Blockdiagramm in Fig. 2 dargelegt, wird das Signal SI1 einem Diskriminator DS1 zugeführt, welcher aus zwei Operationsverstärkern OP2 und OP3 aufgebaut ist. Ein nicht invertierender Eingang des Operationsverstärkers OP2 wird durch einen zwischen der positiven und der negativen Speisespannung (+) und (–) liegenden Spannungsteiler umfassend zwei Widerstände R7 und R8 auf einem Potential festgelegt. Desgleichen wird ein invertierender Eingang des Operationsverstärkers OP3 ebenfalls durch zwischen der positiven und der negativen Speisespannung (+) und (–) liegenden Spannungsteiler umfassend zwei Widerstände R9 und R10 auf einem definierten Potential festgelegt.

Dabei stellen das am nicht invertierenden Eingang des Operationsverstärkers OP2 und das am invertierenden Eingang des Operationsverstärkers OP3 anliegende Potential die beiden Schwellwerte SW1 und –SW1 des Diskriminators dar. Das Signal SI1 wird einem invertierenden Eingang des Operationsverstärkers OP2 und einem nicht invertierenden Eingang des Operationsverstärkers OP3 zugeführt, wobei vor dem nicht invertierenden Eingang des Operationsverstärkers noch ein Widerstand RE liegt. Mittels der Widerstände RE und R11 sowie der Widerstände R7 und R11 werden an den Operationsverstärken OP3 bzw. OP2 Schalthysteresen eingestellt.

Ein Ausgang des Operationsverstärkers OP2 ist zusätzlich noch über einen Widerstand R11 auf den nicht invertierenden Eingang rückgekoppelt, desgleichen ein Ausgang des Operationsverstärkers OP3. Beide Ausgänge der Operationsverstärker OP2 und OP3 sind zusammengefaßt und über einen Widerstand R12 mit der positiven Speisespannung verbunden. An beiden zusammengefaßten Ausgängen der Operationsverstärker OP2 und OP3, welche einen Ausgang des Diskriminators DS1 darstellen, liegt somit ein Puls P1 an.

Der Diskriminator DS2 ist in ähnlicher Weise wie der Diskriminator DS1 aus zwei Operationsverstärkern OP4 und OP5 aufgebaut. Dabei sind ebenfalls ein nicht invertierender Eingang des Operationsverstärkers OP4 und ein invertierender Eingang des Operationsverstärkers OP5 bezüglich ihres Potentials festgelegt, wobei dies bei dem Diskriminator DS2 durch einen aus drei zwischen der positiven Speisespannung und der negativen Speisespannung liegenden Widerständen R13, R14 und R15 aufgebauten Spannungsteiler erfolgt.

Das Potential für den nicht invertierenden Eingang des Operationsverstärkers OP4 wird durch die Widerstände R13 einerseits und R14 und R15 andererseits festgelegt, wohingegen das Potential des invertierenden Eingangs des Operationsverstärkers OP5 einerseits durch die beiden Widerstände R13 und R14 und andererseits durch den Widerstand R15 festgelegt ist.

Das Signal SI2 wird genau wie beim Diskriminator DS1 sowohl einem invertierenden Eingang des Operationsverstärkers OP4 als auch einem nicht invertierenden Eingang des Operationsverstärkers OP5 zugeführt. Ausgänge der Operationsverstärker OP4 und OP5 sind miteinander verbunden und über einen Widerstand R16 gegenüber der positiven Speisespannung (+) festgelegt. Ein an den beiden zusammengefaßten Ausgängen der Operationsverstärker OP4 und OP5 anliegendes Signal wird einer Basis eines Transistors T1 zugeführt, welcher mit Kollektor und Emitter zwischen der positiven Speisespannung (+) und der negativen Speisespannung (–) liegt. Der Transistor T1 invertiert das an den zusammengefaßten Ausgängen der Operationsverstärker OP4 und OP5 anliegende Signal. Zwischen dem Kollektor des Transistors T1 und der positiven Speisespannung liegt noch ein weiterer Widerstand R17. Der Puls P2 wird am Ausgang des Diskriminators DS2 zwischen dem Widerstand R17 und dem Kollektor des Transistors T1 abgegriffen.

Wie bereits in dem Blockdiagramm in Figur 2 erläutert, werden die Pulse P1 und P2 dem Eingang D bzw. T eines statisch getakteten D-Flip-Flops F zugeführt. Dieses ist nun, wie aus Figur 4 ersichtlich, folgendermassen aufgebaut:

Die Grundeinheit wird gebildet aus zwei NAND-Gattern G2 und G3, wobei jeweils ein Eingang eines Gatters mit jeweils einem Ausgang des anderen Gatters verbunden ist. Die beiden freien Eingänge der Gatter G1 und G2 sind in üblicher Weise mit den Buschtaben R und S bezeichnet. Vor dem Eingang R ist ein durch gestrichelte Umrahmung gekennzeichnetes Oderglied OR1 vorgesehen, welches aus zwei parallel zueinander angeordneten Dioden D2 und D3 aufgebaut ist, deren Ausgänge an dem Eingang R liegen. Ein Eingang der Diode D2 ist mit dem Eingang D des statisch getakteten D-Flip-Flops F verbunden, ein Eingang der Diode D3 ist mit dem Eingang T des statisch getakteten D-Flip-Flops verbunden. In gleicher Weise ist vor dem Eingang S des Flip-Flops ein ebenfalls durch gestrichelte Umrahmung gekennzeichnetes Oderglied OR2 vorgesehen, welches ebenfalls aus zwei parallel zueinander geschalteten Dioden D4 und D5 aufgebaut ist, deren Ausgänge mit dem Eingang S des Flip-Flops verbunden sind. Vor einem Eingang der Diode D4 ist noch ein als Inverter geschaltetes NAND-Gatter G1 vorgesehen, dessen Ausgang am Eingang der Diode D4 liegt. Ein Eingang des als Inverter geschalteten Gatters G1 ist mit dem Eingang D des statisch getakteten D-Flip-Flops verbunden. Ein Eingang der Diode D5 liegt direkt am Eingang T des statisch getakteten D-Flip-Flops F. Der Ausgang des Gatters G2 stellt den invertierenden Ausgang Q des statisch getakteten D-Flip-Flops F dar. Zusätzlich ist noch zwischen dem Eingang R und dem Eingang S des Flip-Flops und der negativen Speisespannung jeweils ein Widerstand R18 und R19 vorgesehen.

An dieses statisch getaktete D-Flip-Flop F mit seinem Ausgangssignal Q schliesst sich das in Figur 2 dargestellte Impulshalteglied H an, welches aus einer auf den Ausgang Q folgenden Diode D6, einem mit dieser in Reihe geschalteten Widerstand R20 und einem auf diesen folgenden Zeitglied umfassend einen Widerstand R21 und einen parallel dazu geschalteten Kondensator C3 aufgebaut ist, wobei das Zeitglied einerseits auf der negativen Speisespannung (–) liegt. Sobald am Ausgang Q des statisch getakteten D Flip-Flops F eine 1 anliegt, lässt die Diode D6 durch und lädt somit den Kondensator C3, während die Diode D6 dann blockiert, wenn am Ausgang Q eine Null anliegt, so dass sich der Kondensator C3 nur langsam über den Widerstand R21 entladen kann. Zwischen dem Widerstand R20 und dem Zeitglied, umfassend den Widerstand R21 und dem Kondensator C3, wird ein durch das Zeitglied geglättetes Signal Q abgegriffen und einem Eingang eines als Inverter geschalteten NAND-Gatters G4 zugeführt, welches mit seinem Ausgang über einen Widerstand R22 die Basis eines Ausgangstransistors T2 steuert, der mit seinem Emitter an der positiven Speisespannung (+) liegt und mit seinem Kollektor einmal über einen Kurzschlußschutz K das Ausgangssignal A liefert und außerdem eine Leuchtdiode L ansteuert. Die Leuchtdiode L ist durch eine weitere Diode D7 und einem mit diesem in Reihe geschalteten Widerstand R23 mit der negativen Speisespannung verbunden, wobei die Diode D7 lediglich als Polschutz vorgesehen ist, um einen Durchbruch der Leuchtdiode L zu verhindern. Sobald nun der Ausgangstransistor T2 den Ausgang A ansteuert, Leuchtet gleichzeitig die in der Regel am Schalter angeordnete Leuchtdiode L auf. Als zusätzlicher Polschutz ist noch zwischen dem Kurzschlußschutz K und dem Kollektor des Ausgangstransistors T2 eine Anzapfung vorgesehen, welche mit einem Eingang einer Diode D8 verbunden ist, deren Ausgang an der positiven Speisespannung (+) liegt.

Ein zweites Ausführungsbeispiel des erfindungsgemäßen Näherungsschalters ist in Fig. 5 schematisch dargestellt. Die bei diesem zweiten Ausführungsbeispiel verwendeten Sensoren S1' und S2' sind im Prinzip die gleichen wie die Sensoren S1 und S2 des ersten Ausführungsbeispiels, im Gegensatz zum ersten Ausführungsbeispiel trägt jedoch das Maschinenelement 12 selbst keinen Stabmagneten 32. Die Sensoren S1' und S2' sind ebenfalls wieder so angeordnet, daß ihre Vorzugsrichtungen 18' und 20' parallel zueinander liegen, jedoch in Richtung des Abstandes zwischen den Sensoren S1' und S2' ausgerichtet sind.

Zur Erzeugung des notwendigen Magnetfeldes zum Nachweis des Maschinenelements 12 ist auf einer dem Maschinenelement 12 in seiner nachzuweisenden Stellung entgegengesetzten Seite des Sensors S1' ein Permanentmagnet PM angeordnet, welcher ein den Sensor S1' durchflutendes, in Richtung des Maschinenelements 12 verlaufendes und von dort längs einer ellipsoidförmigen Bahn auf eine dem Sensor S1' abgewandte Seite des Permanentmagnets PN zurücklaufendes Magnetfeld 34' besitzt. Sobald nun das Maschinenelement 12 in seiner nachzuweisenden Stellung, wie in Figur 5 dargestellt, ist wird das Magnetfeld 34' in Richtung des Maschinenelements 12 gezogen und derart deformiert, dass der Sensor S1' in seiner Vorzugsrichtung stärker durchflutet ist, während die Durchflutung des Sensors S1' dann geringer ist, wenn das Maschinenelement 12 aus seiner nachzuweisenden Stellung entfernt ist.

Somit führt eine Annäherung des Maschinenelements 12 in seine nachzuweisende Stellung auch beim zweiten Ausführungsbeispiel dazu, dass der Sensor S1 einen zusätzlichen Anteil eines konstanten Magnetfeldes detektiert. Allerdings ist auch dann, wenn das Maschinenelement 12 nicht in seiner nachzuweisenden Stellung steht ein konstanter Feldanteil im Bereich des Sensors S1 vorhanden, so dass das Signal S1 stets einen konstanten Feldanteil aufweist. Um dieselbe Funktion wie beim ersten Ausführungsbeispiel zu gewährleisten ist es daher notwendig, die Schwellen SW1 und –SW1 nicht symmetrisch zur Nullinie des Signals SI1 anzuordnen, sondern den Referenzwert R1 symmetrisch zu dem konstanten Signalanteil zu legen, welcher auch dann vorhanden ist, wenn das Maschinenelement 12 nicht in seiner nachzuweisenden Stellung steht.

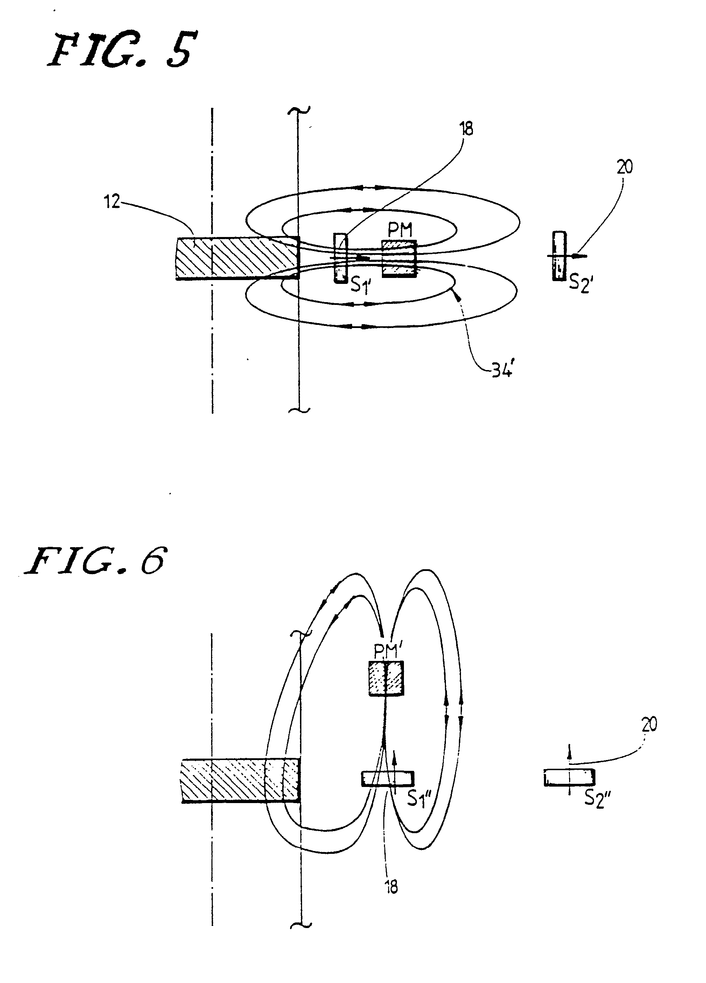

Ein drittes Ausführungsbeispiel des erfindungsgemässen Näherungsschalters ist in Figur 6 dargestellt. Bei diesem besitzt ebenfalls das Maschinenelement 12 selbst keinen Stabmagnet 32, sondern es ist ebenfalls ein Permanentmagnet PM' dem Sensor S1'' zugeordnet. Die Sensoren S1'' und S2'' sind im Prinzip so angeordnet wie beim ersten Ausführungsbeispiel, d.h. ihre beiden Vorzugsrichtungen 18 und 20 stehen parallel zueinander und im wesentlichen senkrecht auf einer Verbindungslinie zwischen den beiden Sensoren S1″ und S2″. Der Permanentmagnet PM′ ist dabei so auf einer Seite des Sensors S1″ angeordnet, dass dieser durch das Magnetfeld 34″ des Permanentmagnets PM′ im wesentlichen in Richtung seiner Vorzugsrichtung 18 durchflutet wird.

Sobald das Maschinenelement 12 in seiner nachzuweisenden Stellung steht, wird das Magnetfeld 34″ in Richtung des Maschinenelements 12 deformiert und somit insgesamt die Durchflutung des Sensors S1″ verringert, so dass bei dem Maschinenelement 12 in seiner nachzuweisenden Stellung der konstante Anteil BS des Signals SI1 verändert ist. Die Schaltung funktioniert im Prinzip genau wie beim ersten Ausführungsbeispiel, jedoch ist, genau wie beim zweiten Ausführungsbeispiel dafür Sorge zu tragen, daß die Schwellwerte SW1 und −SW1 nicht symmetrisch zur Null-Linie des Signals SI1 liegen, sondern symmetrisch zu dem Konstantanteil, welcher den Sensor S1″ dann durchflutet, wenn das Maschinenelement 12 nicht in seiner nachzuweisenden Stellung ist.

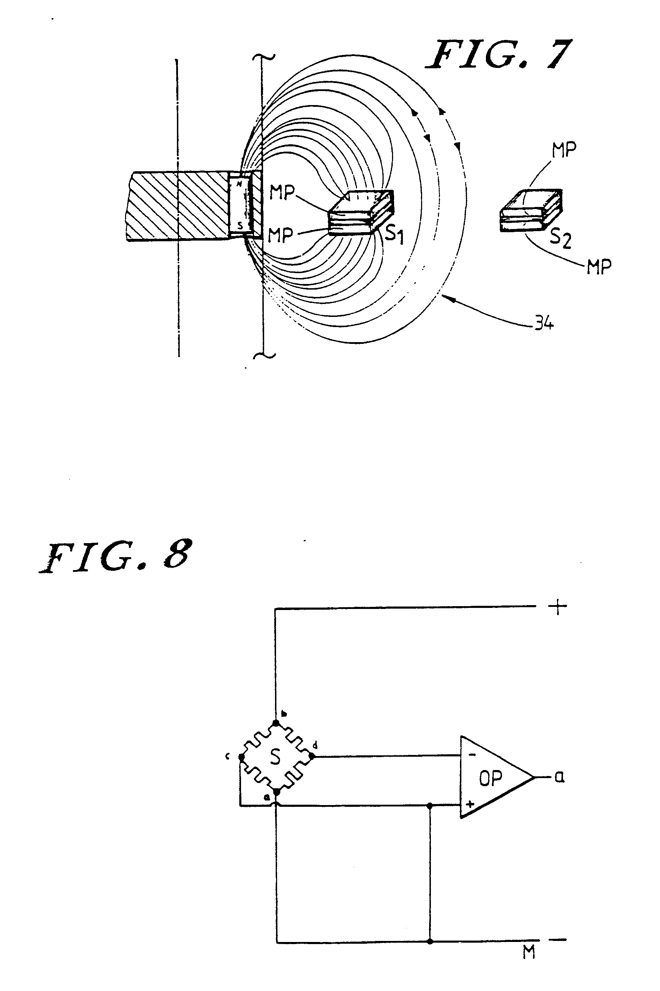

Fig. 7 zeigt ein viertes Ausführungsbeispiel des erfindungsgemäßen Näherungsschalters, welches dem ersten Ausführungsbeispiel im gesamten Aufbau sowie auch in seiner Funktion entspricht, bei dem lediglich die Sensoren S1 und S2 einseitig oder beidseitig mit einem Material MP mit einer magnetischen Suszeptibilität $\mu > 1$ beschichtet sind. Dieses Material bewirkt eine Bündelung der Magnetfelder und führt somit dazu, daß die die Sensoren S1 und S2 durchflutenden Magnetfelder verstärkt werden. Eine derartige Verstärkung der Magnetfelder ist deshalb notwendig, weil die beispielsweise verwendeten Hallsensoren für einen Feldstärkebereich von ungefähr 0 bis zu über 100 kA/m geeignet sind, jedoch bei einem Aufbau gemäß dem ersten Ausführungsbeispiel nur in einem Feldstärkebereich von 0 bis ungefähr 7 oder 8 kA/m ausgenutzt werden. Bei einer derart geringen Ausnutzung des zur Verfügung stehenden Meßbereiches wirken sich Temperaturdriften sehr stark aus. Eine Verringerung der Auswirkung der Temperaturdriften ist dann möglich, wenn durch das Material MP das die Sensoren S1 und S2 durchflutende Magnetfeld verstärkt wird, so daß eine größere Ausnützung des zur Verfügung stehenden Feldstärkebereichs möglich ist und daher sich die Temperaturdriften prozentual geringer auswirken und somit nahezu unterdrückt werden können.

Die vorstehend beschriebenen Hallsensoren sind als komplette Baueinheit zu beziehen. Es ist aber ebenfalls im Rahmen der vorliegenden Erfindung möglich, die Hallsensoren durch Permalloy-Sensoren zu ersetzen, welche jeweils vier als Wheatstone-Brücke zusammengeschaltete Widerstände aus Permalloy umfassen. Diese Widerstände sind im allgemeinen als mäanderförmige Schichten auf einem gemeinsamen Trägersubstrat, beispielsweise einem Siliziumchip, aufgedampft. Hierbei handelt es sich um handelsübliche Permalloy-Sensoren, die z.B. über die Firmen Valvo, Sony oder Siemens bezogen werden können. Jeder der Sensoren S besitzt vier Anschlüsse a, b, c, d (Fig. 8), wobei die Anschlüsse a und b sowie c und d jeweils einander gegenüberliegenden Abgriffen der Wheatstone-Brücke entsprechen.

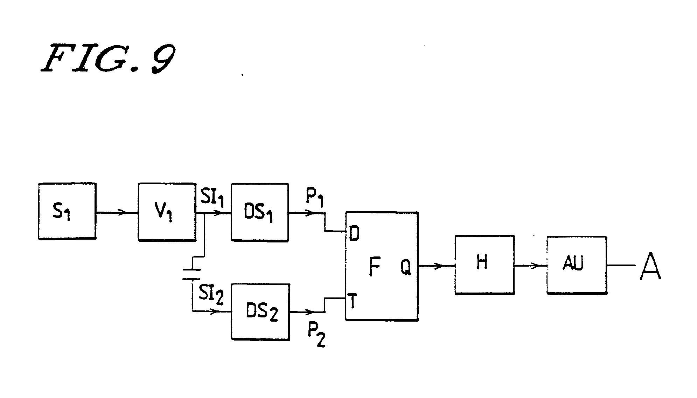

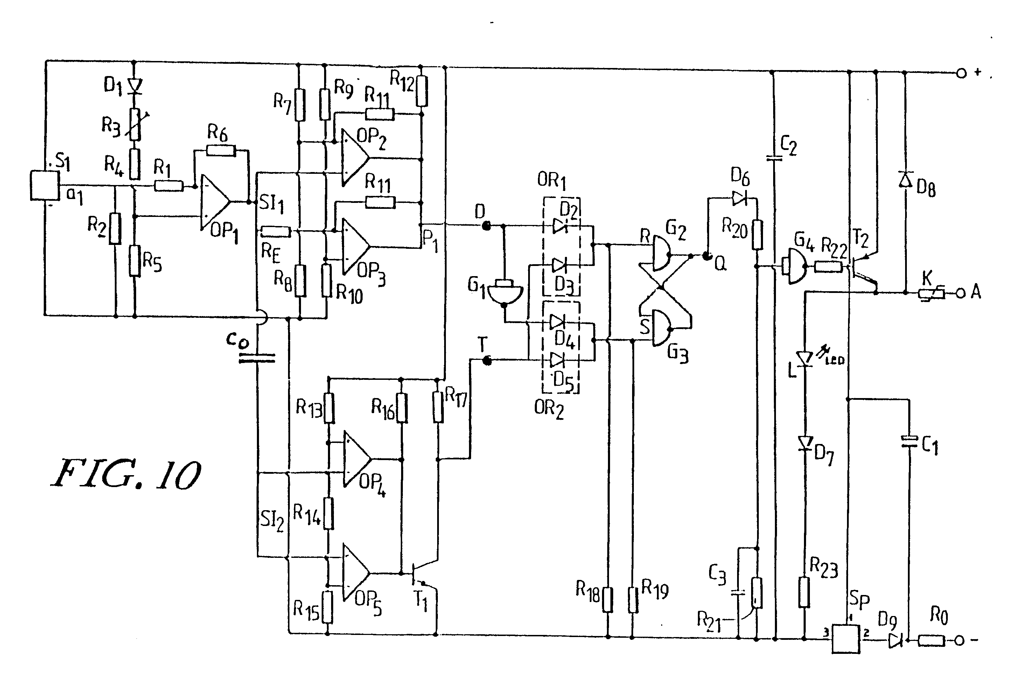

Ein derartiger Sensor S wird, wie Fig. 8 zeigt, mit seinen Anschlüssen a und b an die negative bzw. positive Speisespannung für die Sensoren angelegt, wohingegen die einander gegenüberliegenden Mittelanschlüsse c und d der Wheatstone-Brückenschaltung mit einem invertierenden und einem nichtinvertierenden Eingang eines Operationsverstärkers OP verbunden werden, an dessen Ausgang das Ausgangssignal a des Sensors zur Verfügung steht. Somit kann der Permalloy-Sensor S zusammen mit dem Operationsverstärker OP anstelle der vorstehend beschriebenen Hallsensoren in der Schaltung gemäß Fig. 4 Verwendung finden. Ein fünftes Ausführungsbeispiel, dargestellt in den Figuren 9 und 10, des erfindungsgemäßen Näherungsschalters zeigt eine vereinfachte Version der vorstehend beschriebenen Ausführungen. Diese vereinfachte Version zeichnet sich, wie in Figur 9 dargestellt, dadurch aus, daß der zweite Sensor S2 und der dazugehörige Verstärker V2 entfallen, und daß aus dem den Nachweisfeldsignalanteil NSA und den Störfeldsignalanteil SSA enthaltenden Gesamtsignal SI1 der Störfeldsignalanteil SSA mittels eines Kondensators ausgekoppelt wird und als Signal SI2 dem Diskriminator DS2 zugeführt wird, der hinsichtlich seines Aufbaus mit dem bisher beschriebenen Diskriminator DS2 identisch ist.

Dies zeigt sich auch in der in Figur 10 dargestellten Schaltungsskizze des fünften Ausfürungsbeispiels, die ab dem Punkt, ab dem die Signale SI1 und SI2 vorliegen, mit der des ersten Ausführungsbeispiels in Figur 4 vollkommen identisch ist. Ferner ist auch die Beschaltung des Sensors S1 und des Verstärkers V1 bis zur Erzeugung des Signals SI1 mit der Schaltungsskizze in Figur 4 identisch. Die Schaltungsskizze in Figur 10 unterscheidet von der in Figur 4 dadurch, daß der Sensor S2 und der diesem zugeordnete Verstärker V2 entfallen sind. Anstelle dessen ist der Ausgang des Operationsverstärkers OP1, an welchem das Signal SI1 anliegt, über einen Kondensator CO, der den Störfeldsignalanteil SSA aus dem Signal SI1 auskoppelt und daher das dem Störfeldsignalanteil SSA entsprechende Signal SI2 erzeugt, mit dem invertierenden Eingang des Operationsverstärkers OP4 und dem nicht invertierenden Eingang des Operationsverstärkers OP5 verbunden.

Hinsichtlich der Funktion des vereinfachten fünften Ausführungsbeispiels wird vollinhaltlich auf die Ausführungen zum ersten Ausführungsbeispiel, insbesondere auf die Erläuterungen der Funktion entsprechend Figur 3 Bezug genommen.

Desweiteren kann auch das fünfte Ausführungsbeispiel des erfindungsgemäßen Näherungsschalters in entsprechender Weise wie das erste Ausführungsbeispiel durch die in Verbindung mit dem zweiten, dritten und vierten Ausführungsbeispiel beschriebenen zusätzlichen Maßnahmen verbessert werden.

Bei einem besonders vorteilhaften Ausführungsbeispiel werden in der Schaltung gemäß Fig. 4 oder 9 folgende Bauteile verwendet.

| | Typ | Hersteller |
|---|---|---|
| S1 | 8SSAE1 oder UGN 3503U | Honeywell oder Sprague |
| S2 | 8SSAE1 oder UGN 3503U | Honeywell oder Sprague |
| OP1 | LM 358 | Valvo |
| OP2 | LM 339 | Valvo |
| OP3 | LM 339 | Valvo |
| OP4 | LM 339 | Valvo |
| OP5 | LM 339 | Valvo |
| G1 | 4093 | Valvo |
| G2 | 4093 | Valvo |
| G3 | 4093 | Valvo |
| G4 | 4093 | Valvo |
| SP | 79L05 | Motorola |

| | | |
|---|---|---|
| D1 | BAW56 | Siemens |
| D2 | BAV70 | Siemens |
| D3 | BAV70 | Siemens |
| D4 | BAV70 | Siemens |
| D5 | BAV70 | Siemens |
| D6 | 1/2 BAW101 | Siemens |
| D7 | 1/2 BAW101 | Siemens |
| D8 | ZPY39 | ITT |
| L | CQV35F | Siemens |
| K | Q63100-P2390 | Siemens |
| T1 | BCX707 | Siemens |
| T2 | BST61 | Valvo |
| C0 | 1 µF | |
| C1 | 220 nF | |
| C2 | 6,8 µF | |
| C3 | 100 nF | |
| R0 | 56 Ω | |
| R1 | 10 kΩ | |
| R2 | 1,8 kΩ | |
| R3 | 3,3 kΩ | |
| R4 | 10 kΩ | |
| R5 | 18 kΩ | |
| R6 | 180 kΩ | |
| R7 | 15 kΩ | |
| R8 | 27 kΩ | |
| R9 | 100 kΩ | |
| R10 | 33 kΩ | |
| R11 | 470 kΩ | |
| R12 | 6,8 kΩ | |
| R13 | 47 kΩ | |
| R14 | 6,8 kΩ | |
| R15 | 33 kΩ | |
| R16 | 100 kΩ | |

| | |
|---|---|
| R17 | 6,8 kΩ |
| R18 | 100 kΩ |
| R19 | 100 kΩ |
| R20 | 10 kΩ |
| R21 | 820 kΩ |
| R22 | 3,9 kΩ |
| R23 | 560 Ω |

## Ansprüche

1. Störfeldunempfindlicher Näherungsschalter zum Positionsnachweis eines Maschinenelements (12) mit mindestens einem Sensor (S1), der nahe eines in einer zu detektierenden Stellung stehenden Maschinenelements ein Gesamtsignal (SI1) mit einem durch das Maschinenelement (12) hervorgerufenen Nachweisfeldsignalanteil (NSA) und einem vom Störfeld (40) hervorgerufenen zeitabhängigen Störfeldsignalanteil (SSA) generiert und einem Schaltkreis (V, DS, F, H, AU) übermittelt, welcher das Gesamtsignal (SI1) in ein Ausgangssignal (A) umsetzt, **dadurch gekennzeichnet,** daß das Umsetzen des Gesamtsignals (SI1) in das Ausgangssignal (A) dadurch erfolgt, daß die Zeitabhängigkeit des Störfeldes (40) erfaßt wird, mit dem zeitlichen Auftreten des Störfeldes synchronisierte Tastpulse (P) erzeugt werden, und unter Heranziehung dieser Tastpulse das Gesamtsignal (SI1) daraufhin abgetastet wird, ob es einen dem Störfeldsignalanteil (SSA) überlagerten Signalanteil aufweist, wobei ein während der Abtastung ermittelter Wert dann zu einem das Maschinenelement (12) in seiner nachzuweisenden Stellung anzeigenden Ausgangssignal (A) führt, wenn dieser Wert einen vorwählbaren Mindestwert überschreitet, durch welchen eine für ein Ansprechen des Näherungsschalters erforderliche Mindestfeldstärkenänderung vorwählbar ist.

2. Störfeldunempfindlicher Näherungsschalter nach Anspruch 1, dadurch gekennzeichnet, daß zum Erfassen der Zeitabhängigkeit des Störfeldes (40) der Störfeldsignalanteil (SSA) des Gesamtsignals (SI1) herangezogen wird.

3. Störfeldunempfindlicher Näherungsschalter nach Anspruch 2, dadurch gekennzeichnet, daß der Störfeldsignalanteil (SSA) aus dem Gesamtsignal (SI1) ausgekoppelt und als zweites Signal (SI2) dem Schaltkreis zur Erfassung der Zeitabhängigkeit des Störfeldes (40) übermittelt wird, welcher daraus sogenannte zweite Pulse (P2) als Tastpulse (P) generiert, mit welchem das als erstes Signal (SI1) bezeichnete Gesamtsignal abgetastet wird.

4. Störfeldunempfindlicher Näherungsschalter nach Anspruch 1, dadurch gekennzeichnet, daß ein zweiter Sensor (S2) vorgesehen ist, welcher einen größeren Abstand von dem in einer zu detektierenden Stellung stehenden Maschinenelement (12) aufweist als der erste Sensor (S1) und ein einen Störfeldsignalanteil (SSA) umfassendes zweites Signal (SI2) generiert, und daß zum Erfassen der Zeitabhängigkeit des Störfeldes entweder aus dem von ersten Sensor erzeugten ersten Signal (SI1) oder aus dem vom zweiten Sensor (S2) erzeugten zweiten Signal (SI2) die der Zeitabhängigkeit des Störfeldes (40) entsprechende Folge von ersten Pulsen (P1) bzw. von zweiten Pulsen (P2) als Tastpulse (P) gewonnen und mittels diesen Tastpulsen das zweite (SI2) bzw. das erste Signal (SI1) abgetastet wird.

5. Störfeldunempfindlicher Näherungsschalter nach Anspruch 3 oder 4, dadurch gekennzeichnet, daß die ersten Pulse (P1) bzw. die zweiten Pulse (P2) zu jedem Zeitpunkt generiert werden, zu dem das erste Signal (SI1) bzw. das zweite Signal (SI2) einen Referenzwert (R1) bzw. (R2) durchläuft.

6. Störfeldunempfindlicher Näherungsschalter nach einem der Ansprüche 3 bis 5, dadurch gekennzeichnet, daß zu jedem Zeitpunkt, zu dem das am ersten Sensor (S1) erzeugte erste Signal (SI1) einen ersten Referenzwert (R1) durchläuft, ein erster Puls (P1) generiert wird, daß zu jedem Zeitpunkt, zu dem das am zweiten Sensor (S2) erzeugte zweite Signal (SI2) einen zweiten Referenzwert (R2) durchläuft, ein zweiter Puls (P2) generiert wird, und daß ein zeitlicher Abstand zwischen dem ersten und dem zweiten Puls dem ermittelten Wert entspricht, wobei der vorwählbare Mindestwert eine vorwählbare Mindestzeit darstellt.

7. Störfeldunempfindlicher Näherungsschalter nach Anspruch 6, dadurch gekennzeichnet, daß zur Ermittlung des zeitlichen Abstandes mindestens ein Pulskoinzidenzen feststellendes Glied (F) vorgesehen ist.

8. Störfeldunempfindlicher Näherungsschalter nach einem der Ansprüche 4 bis 7, dadurch gekennzeichnet, daß der erste Puls (P1) zeitlich verbreitert ist.

9. Störfeldunempfindlicher Näherungsschalter nach einem der Ansprüche 3 bis 8, dadurch gekennzeichnet, daß der zweite Puls (P2) zeitlich verbreitert ist.

10. Störfeldunempfindlicher Näherungsschalter nach Anspruch 1 oder 2, dadurch gekennzeichnet, daß der Tastpuls (P) zeitlich verbreitert ist.

11. Störfeldunempfindlicher Näherungsschalter nach einem der Ansprüche 8 bis 10, dadurch gekennzeichnet, daß eine Verbreiterung durch beiderseits des jeweiligen Referenzwerts (R1, R2) liegende Schwellwerte (SW1, –SW1 ; SW2, –SW2) erfolgt, wobei ein Puls (P, P1, P2) dann generiert wird, wenn das jeweilige Signal (SI1, SI2) zwischen diesen Schwellwerten (SW1, –SW1 ; SW2, –SW2) liegt.

12. Störfeldunempfindlicher Näherungsschalter nach Anspruch 11, dadurch gekennzeichnet, daß die Schwellwerte (SW1, –SW1 ; SW2, –SW2) symmetrisch zu dem jeweiligen Referenzwert (R1, R2) liegen.

13. Störfeldunempfindlicher Näherungsschalter nach einem der voranstehenden Ansprüche, dadurch gekennzeichnet, daß der erste Puls (P1) im Bereich eines Null-Durchgangs des ersten Signals (SI1) generiert wird.

14. Störfeldunempfindlicher Näherungsschalter nach einem der voranstehenden Ansprüche, dadurch gekennzeichnet, daß der zweite Puls (P2) im Bereich eines Null-Durchgangs des zweiten Signals (SI2) generiert wird.

15. Störfeldunempfindlicher Näherungsschalter nach einem der Ansprüche 8 bis 14, dadurch gekennzeichnet, daß der zeitliche Abstand durch Feststellung einer Koinzidenz des verbreiterten ersten (P1) oder zweiten Pulses (P2) mit dem zweiten (P2) bzw. ersten Puls (P1) ermittelt wird.

16. Störfeldunempfindlicher Näherungsschalter nach einem der Ansprüche 7 bis 15, dadurch gekennzeichnet, daß der zeitliche Abstand durch Festellung einer Koinzidenz des verbreiterten ersten (P1) mit dem verbreiterten zweiten Puls (P2) ermittelt wird.

17. Störfeldunempfindlicher Näherungsschalter nach einem der Ansprüche 7 bis 16, dadurch gekennzeichnet, daß als Pulskoinzidenzen feststellendes Glied ein statisch getaktetes D-Flip-Flop (F) mit folgender Wahrheitstafel

| D | T | Q | |
|---|---|---|---|
| O | O | 1 | |
| 1 | O | O | |
| O | 1 | } vor dem Übergang |
| 1 | 1 | } von T = O nach T = 1 anliegender D-Wert invertiert |

D }
  } Eingänge des statisch
  } getakteten D-Flip-
T } Flops

Q   invertierter Ausgang
    des statisch getakteten
    D-Flip-Flops

verwendet wird.

18. Störfeldunempfindlicher Näherungsschalter nach einem der Ansprüche 7 bis 17, dadurch gekennzeichnet, daß auf einen Ausgang (Q) des Pulskoinzidenzen feststellenden Gliedes (F) folgend ein Halteglied (H) vorgesehen ist.

19. Störfeldunempfindlicher Näherungsschalter nach Anspruch 15, dadurch gekennzeichnet, daß das Halteglied (H) ein Ausgangssignal des Pulskoinzidenzen feststellenden Gliedes (F) über mindestens eine halbe Periodendauer des Störfeldes (40) hält.

20. Störfeldunempfindlicher Näherungsschalter nach einem der Ansprüche 4 bis 19, dadurch gekennzeichnet, daß der erste Sensor (S1) in einem der Gleichung

$$r = \frac{d}{k - 1}$$

r = Mindestabstand des ersten
    Sensors von einer Quelle
    des Störfeldes

d = Sensorabstand

k = Verhältnis der Breite des
    ersten zur Breite des
    zweiten Pulses

entsprechenden Mindestabstand von einer Quelle des Störfeldes (40) angeordnet ist.

21. Störfeldunempfindlicher Näherungsschalter nach einem der voranstehenden Ansprüche, dadurch gekennzeichnet, daß die Sensoren (S1, S2) eine Vorzugsrichtung (18, 20) aufweisen und so angeordnet sind, daß die Vorzugsrichtungen (18, 20) parallel zueinander stehen.

22. Störfeldunempfindlicher Näherungsschalter nach einem der voranstehenden Ansprüche, dadurch gekennzeichnet, daß die Sensoren (S1, S2) Magnetfeldsensoren sind.

23. Störfeldunemfindlicher Näherungsschalter nach Anspruch 22, dadurch gekennzeichnet, daß dem ersten Sensor (S1) ein Permanentmagnet (PM) zugeordnet ist, welcher mit seinem Magnetfeld den ersten Sensor (S1) in Richtung seiner Vorzugsrichtung (18) durchflutet.

24. Störfeldunempfindlicher Näherungsschalter nach Anspruch 23, dadurch gekennzeichnet, daß der Permanentmagnet (PM) mit einem Nord- oder einem Südpol dem ersten Sensor (S1) zugewandt angeordnet ist.

25. Störfeldunempfindlicher Näherungsschalter nach Anspruch 23 oder 24, dadurch gekennzeichnet, daß der erste Referenzwert (R1) einem ersten Signal (SI1) bei Abwesenheit des Störfeldes (40) und bei Abwesenheit des Maschinenelements (12) in seiner zu detektierenden Stellung entspricht.

26. Störfeldunempfindlicher Näherungsschalter nach einem der voranstehenden Ansprüche, dadurch gekennzeichnet, daß die Sensoren (S1, S2) so angeordnet sind, daß deren Vorzugsrichtungen (18, 20) in Richtung einer Verbindungslinie der Sensoren (S1, S2) weisen und daß der Permanentmagnet (PM) auf einer dem Maschinenelement (12) in seiner zu detektierenden Stellung abgewandten Seite des ersten Sensors (S1) angeordnet ist.

27. Störfeldunempfindlicher Näherungsschalter nach einem der Ansprüche 23 bis 25, dadurch gekennzeichnet, daß die Sensoren (S1, S2) so angeordnet sind, daß ihre Vorzugsrichtungen (18, 20) ungefähr senkrecht auf einer Verbindungslinie der Sensoren (S1, S2) stehen.

28. Störfeldunempfindlicher Näherungsschalter nach einem der voranstehenden Ansprüche, dadurch gekennzeichnet, daß die Sensoren (S1, S2) Hallsensoren sind.

29. Störfeldunempfindlicher Näherungsschalter nach einem der Ansprüche 1 bis 27, dadurch gekennzeichnet, daß die Sensoren (S1, S2) magnetoresistive Sensoren sind.

30. Störfeldunempfindlicher Näherungsschalter nach Anspruch 29, dadurch gekennzeichnet, daß die Sensoren (S1, S2) Permalloy-Sensoren sind.

31. Störfeldunempfindlicher Näherungsschalter nach einem der voranstehenden Ansprüche, dadurch gekennzeichnet, daß auf einer aktiven Fläche von mindestens einem der Sensoren (S1, S2) ein Material mit einer Suszeptibilität $\mu > 1$ angeordnet ist.

## Claims

1. Interference field-insensitive proximity detector for identifying the position of a machine element (12) with at least one sensor (S1), which, when close to a machine element in the position to be detected, generates a total signal (SI1) with an identification field signal component (NSA) produced by the machine element (12) and a time-dependent interference field signal component (SSA) produced by the interference field (40) and transmits said signal to a circuit (V, DS, F, H, AU) which converts the global signal (SI1) into an output signal (A), characterised in that the conversion of the total signal (SI1) into the output signal (A) is effected in that the time-dependency of the interference field (40) is detected, scanning pulses (P) are generated synchronised with the temporal occurrence of the interference field, and the total signal (SI1) is then scanned by using these scanning pulses to ascertain whether it has a signal component superimposed on the interference field signal component (SSA), in which case a value determined during scanning then leads to an output signal (A) indicating the machine element (12) in its position to be identified if this value exceeds a preselectable minimum, by means of which a minimum field strength change is preselectable for response of the proximity detector.

2. Interference field-insensitive proximity detector according to claim 1, characterised in that, to determine the time-dependency of the interference field (40), the interference field signal component (SSA) of the total signal (SI1) is used.

3. Interference field-insensitive proximity detector according to claim 2, characterised in that the interference field signal component (SSA) is coupled out from the total signal (SI1) and is transmitted as a second signal (SI2) to the circuit for determining the time-dependency of the interference field (40), which generates therefrom so-called second pulses (P2) as scanning pulses (P), with which the total signal referred to as the first signal (SI1) is scanned.

4. Interference field-insensitive proximity detector according to claim 1, characterised in that a second sensor (S2) is provided which has a greater distance from the machine element (12) located at a position to be detected than the first sensor (S1) and generates a second signal (SI2) comprising an interference field signal component (SSA), and in that to determine the time-dependency of the interference field, either from the first signal (SI1) generated by the first sensor or from the second signal (SI2) generated by the second sensor (S2), the sequence of first pulses (P1) corresponding to the time-dependency of the interference field (40) or of second pulses (P2) are obtained as scanning pulses (P) and by means of these scanning pulses the second (SI2) or first signal (SI1) is scanned.

5. Interference field-insensitive proximity detector according to claim 3 or 4, characterised in that the first pulses (P1) or the second pulses (P2) are generated at any point in time at which the first signal (SI1) or respectively the second signal (SI2) passes through a reference value (R1) or (R2) respectively.

6. Interference field-insensitive proximity detector according to one of claims 3 to 5, characterised in that at any time at which the first signal (SI1) generated at the first sensor (S1) passes through a first reference value (R1), a first pulse (P1) is generated, in that at any time at which the second signal (SI2) generated at the second sensor (S2) passes through a second reference value (R2), a second pulse (P2) is generated, and in that a time lag between the first and second pulse corresponds to the value detected, in which case the preselectable minimum value is a preselectable minimum time.

7. Interference field-insensitive proximity detector according to claim 6, characterised in that to determine the time lag at least one member (F) for detecting pulse coincidences is provided.

8. Interference field-insensitive proximity detector according to one of claims 4 to 7, characterised in that the first pulse (P1) is temporarily widened.

9. Interference field-insensitive proximity detector according to one of claims 3 to 8, characterised in that the second pulse (P2) is temporarily widened.

10. Interference field-insensitive proximity detector according to claim 1 or 2, characterised in that the scanning pulse (P) is temporarily widened.

11. Interference field-insensitive proximity detector according to one of claims 8 to 10, characterised in that widening takes place by threshold values (SW1, –SW1 ; SW2, –SW2) on either side of the respective reference value (R1, R2), and a pulse (P, P1, P2) is then generated if the respective signal (SI1, SI2) lies between these threshold values (SW1, –SW1 ; SW2, –SW2).

12. Interference field-insensitive proximity detector according to claim 11, characterised in that the threshold values (SW1, –SW1 ; SW2, –SW2) are symmetrical to the respective reference value (R1, R2).

13. Interference field-insensitive proximity detector according to one of the preceding claims, characterised in that the first pulse (P1) is generated in the range of a zero passage of the first signal (SI1).

14. Interference field-insensitive proximity detector according to one of the preceding claims, characterised in that the second pulse (P2) is generated in the range of a zero passage of the second signal (SI2).

15. Interference field-insensitive proximity detector according to one of claims 8 to 14, characterised in that the time lag is detected by ascertaining a coincidence of the widened first (P1) or second pulse (P2) with the second (P2) or first pulse (P1) respectively.

16. Interference field-insensitive proximity detector according to one of claims 7 to 15, characterised in that the time lag is detected by ascertaining a coincidence of the widened first (P1) with the widened second pulse (P2).

17. Interference field-insensitive proximity detector according to one of claims 7 to 16, characterised in that as a member for ascertaining pulse coincidences, a static, timed D-flip-flop (F) is used, having the following truth table :

```
  D │ T │ Q
  ──┼───┼───
  0 │ 0 │ 1
  1 │ 0 │ 0
  0 │ 1 │ ⎫D-value present before transition
  1 │ 1 │ ⎭from T = 0 to T = 1 is inverted
```

D, T : inputs of the statically timed D-flip-flop
Q : inverted output of the statically timed D-flip-flop

18. Interference field-insensitive proximity detector according to one of claims 7 to 17, characterised in that a holding member (H) is provided, following an output (Q) of the member (F) for detecting pulse coincidences.

19. Interference field-insensitive proximity detector according to claim 15, characterised in that the holding member (H) holds an output signal of the pulse coincidence-detecting member (F) for at least half the duration of a period of the interference field (40).

20. Interference field-insensitive proximity detector according to one of claims 4 to 19, characterised in that the first sensor (S1) is mounted at a minimum distance from a source of the interference field (40) corresponding to the equation

$$r = \frac{d}{k - 1}$$

where r = minimum distance of the first sensor from a source of the interference field,
d = the sensor distance and
k = the ratio of the breadth of the first pulse to the breadth of the second pulse.

21. Interference field-insensitive proximity detector according to one of the preceding claims, characterised in that the sensors (S1, S2) have a preferential direction (18, 20) and are so arranged that the preferential directions (18, 20) are parallel to one another.

22. Interference field-insensitive proximity detector according to one of the preceding claims, characterised in that the sensors (S1, S2) are magnetic field sensors.

23. Interference field-insensitive proximity detector according to claim 22, characterised in that a permanent magnet (PM), whose magnetic field flows through the first sensor (S1) in its preferential direction (18), is associated with the first sensor (S1).

24. Interference field-insensitive proximity detector according to claim 23, characterised in that the permanent magnet (PM) is arranged with a north or a south pole facing the first sensor (S1).

25. Interference field-insensitive proximity detector according to claim 23 or 24, characterised in that the first reference value (R1) corresponds to a first signal (SI1) in the absence of the interference field (40) and in the absence of the machine element (12) in its position to be detected.

26. Interference field-insensitive proximity detector according to one of the preceding claims, characterised in that the sensors (S1, S2) are so arranged that their preferential directions (18, 20) point in the direction of a joining line of the sensors (S1, S2) and in that the permanent magnet (PM) is mounted on a side of the first sensor (S1) remote from the machine element (12) in its position to be detected.

27. Interference field-insensitive proximity detector according to one of claims 23 to 25, characterised in that the sensors (S1, S2) are so arranged that their preferential directions (18, 20) are approximately perpendicular to a joining line of the sensors (S1, S2).

28. Interference field-insensitive proximity detector according to one of the preceding claims, characterised in that the sensors (S1, S2) are Hall sensors.

29. Interference field-insensitive proximity detector according to one of claims 1 to 27, characterised in that the sensors (S1, S2) are magnetoresistive sensors.

30. Interference field-insensitive proximity detector according to claim 29, characterised in that the sensors (S1, S2) are permalloy sensors.

31. Interference field-insensitive proximity detector according to one of the preceding claims, characterised in that on an active surface of at least one of the sensors (S1, S2), a material with a susceptibility of $\mu > 1$ is provided.

## Revendications

1. Détecteur de proximité insensible aux champs parasitaires destiné à l'identification de la position d'un élément de machine (12) comprenant au moins un détecteur (S1), qui engendre à proximité d'un élément de machine se trouvant dans une position à détecter, un signal total (SI1) comportant une partie de signal du champ d'identification (NSA) provoqué par l'élément de machine (12) et une partie de signal du champ parasitaire variable dans le temps, qui est provoqué par un champ parasitaire (40) et qui le retransmet à un circuit (V, DS, F, H, AU), qui transforme le signal total (SI1) en un signal de sortie (A), caractérisé en ce que la transformation du signal total (SI1) en le signal de sortie (A) a lieu par le fait que la dépendance par rapport au temps du champ parasitaire (40) est saisie, en ce que des impulsions de balayage (P) synchronisées avec l'apparition dans le temps du champ parasitaire sont produites et en ce qu'avec la prise en compte de ces impulsions de balayage le signal total (SI1) est balayé pour voir si celui-ci présente une partie de signal superposée à la partie de signal du champ parasitaire (SSA), une valeur déterminée pendant le balayage conduisant alors à un signal de sortie (A) indiquant l'élément de machine (12) dans sa position à identifier, lorsque cette valeur dépasse une valeur minimale présélectionnable par laquelle une variation d'intensité de champ minimale nécessaire pour une réponse du détecteur de proximité est sélectionnable.

2. Détecteur de proximité insensible aux champs parasitaires suivant la revendication 1, caractérisé en ce que pour la saisie de la dépendance par rapport au temps du champ parasitaire (40) la partie de signal du champ parasitaire (SSA) du signal total (SI1) est prise en compte.

3. Détecteur de proximité insensible aux champs parasitaires suivant la revendication 2, caractérisé en ce que la partie de signal de champ parasitaire (SSA) est découplée du signal total (SI1) et est transmise comme deuxième signal (SI2) au circuit pour la saisie de la dépendance par rapport au temps du champ parasitaire (40), celui-ci engendrant à partir de cela ce que l'on appelle des deuxièmes impulsions (P2) comme impulsions de balayage (P) par lesquelles le signal total désigné comme premier signal (SI1) est balayé.

4. Détecteur de proximité insensible aux champs parasitaires suivant la revendication 1, caractérisé en ce qu'il est prévu un deuxième détecteur (S2), qui présente une plus grande distance par rapport à l'élément de machine (12) se trouvant dans une position à détecter que le premier détecteur (S1) et qui engendre un deuxième signal (SI2) comprenant une partie de signal du champ parasitaire (SSA), et en ce que pour saisir la dépendance par rapport au temps du champ parasitaire, la série de premières impulsions (P1) et respectivement de deuxièmes impulsions (P2) correspondant à la dépendance par rapport au temps du champ parasitaire (40) est extraite sous la forme d'impulsions de balayage soit à partir du premier signal (SI1) produit par le premier détecteur, soit à partir du deuxième signal (SI2) produit par le deuxième détecteur (S2), les deuxième (SI2) et respectivement premier signaux (SI1) étant balayés au moyen de ces impulsions de balayage.

5. Détecteur de proximité insensible aux champs parasitaires suivant la revendication 3 ou 4, caractérisé en ce que les premières impulsions (P1) et respectivement les deuxièmes impulsions (P2) sont engendrées à chaque instant auquel le premier signal (SI1) et respectivement le deuxième signal (SI2) passent par une valeur de référence (R1) et respectivement (R2).

6. Détecteur de proximité insensible aux champs parasitaires suivant l'une des revendications 3 à 5, caractérisé en ce qu'à chaque instant auquel le premier signal (SI1) produit à hauteur du premier détecteur (S1) passe par une première valeur de référence (R1) une première impulsion (P1) est engendrée, en ce qu'à chaque instant auquel le deuxième signal (SI2) produit au deuxième détecteur (S2) passe par une deuxième valeur de référence (R2) une deuxième impulsion (P2) est engendrée et en ce qu'une distance dans le temps entre la première et la deuxième impulsion correspond à la valeur déterminée, la valeur minimale présélectionnable représentant un temps minimal présélectionnable.

7. Détecteur de proximité insensible aux champs parasitaires suivant la revendication 6, caractérisé en ce que pour déterminer la distance dans le temps il est prévu au moins un organe (F) de constatation des coïncidences d'impulsions.

8. Détecteur de proximité insensible aux champs parasitaires suivant l'une des revendications 4 à 7, caractérisé en ce que la première impulsion (P1) est élargie dans le temps.

9. Détecteur de proximité insensible aux champs parasitaires suivant l'une des revendications 3 à 8, caractérisé en ce que la deuxième impulsion (P2) est élargie dans le temps.

10. Détecteur de proximité insensible aux champs parasitaires suivant la revendication 1 ou 2, caractérisé en ce que l'impulsion de balayage (P) est élargie dans le temps.

11. Détecteur de proximité insensible aux champs parasitaires suivant l'une des revendications 8 à 10, caractérisé en ce qu'un élargissement a lieu par des valeurs de seuil (SW1, −SW1 ; SW2,−SW2) situées des deux côtés de chaque valeur de référence (R1, R2), une impulsion (P, P1, P2) étant engendrée lorsque chaque signal (SI1, SI2) est situé entre ces valeurs de seuil.

12. Détecteur de proximité insensible aux champs parasitaires suivant la revendication 11, caractérisé en ce que les valeurs de seuil (SW1, −SW1 ; SW2, −SW2) sont situées symétriquement par rapport à chaque valeur de référence (R1, R2).

13. Détecteur de proximité insensible aux champs parasitaires suivant l'une des revendications précédentes, caractérisé en ce que la première impulsion (P1) est engendrée dans la zone d'un passage par zéro du premier signal (SI1).

14. Détecteur de proximité insensible aux champs parasitaires suivant l'une des revendications précédentes, caractérisé en ce que la deuxième impulsion (P2) est engendrée dans la zone d'un passage par zéro du deuxième signal (SI2).

15. Détecteur de proximité insensible aux champs parasitaires suivant l'une des revendications 8 à 14, caractérisé en ce que la distance dans le temps est déterminée par la constatation d'une coïncidence de la première (P1) ou de la deuxième impulsion élargie (P2) avec la deuxième (P2), respectivement première impulsion (P1).

16. Détecteur de proximité insensible aux champs parasitaires suivant l'une des revendications 7 à 15, caractérisé en ce que la distance dans le temps est déterminée par la constatation d'une coïncidence de la première impulsion élargie (P1) avec la deuxième impulsion élargie (P2).

17. Détecteur de proximité insensible aux champs parasitaires suivant l'une des revendications 7 à 16, caractérisé en ce qu'il est utilisé comme organe de constatation des coïncidences d'impulsions une bascule du type D synchronisée statiquement (F) présentant la table de vérité suivante

| D | T | Q |
|---|---|---|
| 0 | 0 | 1 |
| 1 | 0 | 0 |
| 0 | 1 | } |
| 1 | 1 | } |

la valeur D présentée est inversée avant le passage de T = 0 à T = 1

D } entrées de la bascule de type D
T } synchronisée statiquement

Q   sortie inversée de la bascule de type D synchronisée statiquement.

18. Détecteur de proximité insensible aux champs parasitaires suivant l'une des revendications 7 à 17, caractérisé en ce qu'il est prévu directement à une sortie (Q) de l'organe de constatation des coïncidences d'impulsions (F) un organe de maintien (H).

19. Détecteur de proximité insensible aux champs parasitaires suivant la revendication 15, caractérisé en ce que l'organe de maintien (H) conserve un signal de sortie de l'organe de constatation des coïncidences d'impulsions (F) pendant au moins une demi-période du champ parasitaire (40).

20. Détecteur de proximité insensible aux champs parasitaires suivant l'une des revendications 4 à 19, caractérisé en ce que le premier détecteur (S1) est agencé à au moins une distance correspondant à l'équation

$$r = \frac{d}{k - 1}$$

r = distance minimale entre le premier détecteur et une source du champ parasitaire
d = distance de détecteur
k = rapport entre les largeurs des première et deuxième impulsions d'une source du champ parasitaire (40).

21. Détecteur de proximité insensible aux champs parasitaires suivant l'une des revendications précédentes, caractérisé en ce que les détecteurs (S1, S2) présentent une orientation préférentielle (18, 20) et en ce que ceux-ci sont agencés de manière à ce que les orientations préférentielles (18, 20) soient parallèles l'une à l'autre.

22. Détecteur de proximité insensible aux champs parasitaires suivant l'une des revendications précédentes, caractérisé en ce que les détecteurs (S1, S2) consistent en détecteurs de champs magnétiques.

23. Détecteur de proximité insensible aux champs parasitaires suivant la revendication 22, caractérisé en ce qu'il est adjoint au premier détecteur (S1) un aimant permanent (PM) qui traverse avec son champ magnétique le premier détecteur (S1) en direction de son orientation préférentielle (18).

24. Détecteur de proximité insensible aux champs parasitaires suivant la revendication 23, caractérisé en ce que l'aimant permanent (PM) est agencé avec un pôle nord ou sud de manière adjacente au premier détecteur (S1).

25. Détecteur de proximité insensible aux champs parasitaires suivant la revendication 23 ou 24, caractérisé en ce que la première valeur de référence (R1) correspond à un premier signal (SI1) en cas d'absence du champ parasitaire (40) et en cas d'absence de l'élément de machine (12) dans sa position à détecter.

26. Détecteur de proximité insensible aux champs parasitaires suivant l'une des revendications précédentes, caractérisé en ce que les détecteurs (S1, S2) sont agencés de manière telle que leurs orientations préférentielles (18, 20) pointent en direction d'une ligne de liaison des détecteurs (S1, S2) et en ce que l'aimant permanent (PM) est agencé sur un côté du premier détecteur (S1), qui est opposé à l'élément de machine (12) dans sa position à détecter.

27. Détecteur de proximité insensible aux champs parasitaires suivant l'une des revendications 23 à 25, caractérisé en ce que les détecteurs (S1, S2) sont agencés de manière à ce que leurs orientations préférentielles (18, 20) soient approximativement perpendiculaires à une ligne de liaison des détecteurs (S1, S2).

28. Détecteur de proximité insensible aux champs parasitaires suivant l'une des revendications précédentes, caractérisé en ce que les détecteurs (S1, S2) consistent en détecteurs à effet Hall.

29. Détecteur de proximité insensible aux champs parasitaires suivant l'une des revendications 1 à 27, caractérisé en ce que les détecteurs (S1, S2) consistent en détecteurs magnétorésistifs.

30. Détecteur de proximité insensible aux champs parasitaires suivant la revendication 29, caractérisé en ce que les détecteurs (S1, S2) consistent en détecteurs de permalloy.

31. Détecteur de proximité insensible aux champs parasitaires suivant l'une des revendications précédentes, caractérisé en ce qu'il est agencé sur une surface active d'au moins l'un des détecteurs (S1, S2) une matière présentant une susceptibilité $\mu > 1$.

# FIG.1

# FIG. 2

# FIG.3

FIG. 4

EP 0 283 487 B1

# FIG. 5

# FIG. 6

FIG. 7

FIG. 8

## FIG.9

FIG. 10

EP 0 283 487 B1